# EUROPEAN PATENT APPLICATION

(11) **EP 2 879 195 A1**
(43) Date of publication of application: **03.06.2015**
(21) Application number: 13823059.4
(22) Date of filing: 26.07.2013
(51) Int. Cl.: H01L 33/60

(54) **LED DEVICE AND METHOD FOR MANUFACTURING SAME**

(30) Priority: 27.07.2012 JP 2012167100; 18.09.2012 JP 2012204316
(71) Applicant: Konica Minolta, Inc., Tokyo 100-7015 (JP)
(72) Inventor: WASHIZU, Takashi, (JP)
(74) Representative: Henkel, Breuer & Partner
(86) International application number: PCT/JP2013/004567
(87) International publication number: WO 2014/017108

(57) **Abstract**

The present invention addresses the problem of providing an LED device, which has less deterioration of a reflecting layer for reflecting output light from an LED element, and the like, and which is capable of efficiently taking out light over a long period of time, and a method for manufacturing the LED device. In order to solve the problem, the present invention relates to an LED device having a substrate, and an LED element, which is mounted on the substrate, and which outputs light having a specific wavelength. On a surface of the substrate outside of the LED element-mounted region, the device has a reflecting layer that contains light diffusing particles formed of inorganic particles, and a ceramic binder.

## Description

### Technical Field

The present invention relates to an LED device and a method of manufacturing the same.

### Background Art

Recently, there has been developed a white LED device in which a phosphor is disposed in the vicinity of an LED device and which obtains white light by exciting the phosphor with light from the LED element. Examples of the LED device include an LED device that obtains white light by combining blue light from a blue LED element and yellow fluorescence emanated by a phosphor upon receipt of blue light. Further, there is also an LED device that emits white light by mixing blue light, green light, and red light emanated by phosphors upon receipt of ultraviolet light, where an LED element emitting ultraviolet light is used as a light source.

Conventional LED devices have the problem of insufficient out-coupling efficiency due to easy absorption of emission light from an LED element or fluorescence from phosphors by the substrate or other component on which the LED element is mounted. Under such circumstances, a general LED device has a reflector having high light reflectivity being disposed around an LED element. Such a reflector is generally made of a plated metal or the like.

However, a reflector made of a plated metal cannot be formed on the entire surface of the substrate in order to prevent electrical conduction. Therefore, there has been a problem in which light is absorbed by the substrate in an area where no reflector is formed.

On the other hand, there are also proposed a reflector in which a plated metal is covered with a resin layer (PTL 1), and a reflector in which a plated metal is covered with a white resin layer (PTL 2).

### Citation List

### Patent Literature

PTL 1
   Japanese Patent Application Laid-Open No. 2005-136379
PTL 2
   Japanese Patent Application Laid-Open No. 2011-23621

### Summary of Invention

### Technical Problem

However, in the vicinity of a reflector, light is multiply scattered. Therefore, there have been problems in which, when a reflector is composed of a resin, or when a reflector surface composed of a plated metal is covered with a resin as in the techniques disclosed in PTLS 1 and 2, the resin is deteriorated due to heat or light, causing the light reflectivity of the reflection layer to be lowered over time and causing electricity to be conducted. In particular, in applications requiring larger amount of light such as a headlight to be mounted on an automobile, the resin is likely to be deteriorated.

The present invention has been achieved in view of these circumstances. That is, the present invention provides an LED device capable of efficiently out-coupling light over a long period of time with less deterioration of a reflection layer for reflecting an emission light or the like from an LED element, and a method of manufacturing the same.

### Solution to Problem

A first aspect of the present invention relates to LED devices set forth below.
[1] An LED device including: a substrate; and an LED element that is mounted on the substrate and configured to emit light of a specific wavelength, wherein the LED device includes a reflection layer including light diffusion particles composed of inorganic particles and a ceramic binder on a surface of the substrate outside an LED element-mounting area.
[2] The LED device according to [1], wherein the thickness of the reflection layer is 5 µm or more and 200 µm or less.
[3] The LED device according to [1], wherein the thickness of the reflection layer is 5 µm or more and 30 µm or less.
[4] The LED device according to any one of [1] to [3], wherein the substrate has a cavity, and the LED device includes the reflection layer on an inner wall surface of the cavity.
[5] The LED device according to any one of [1] to [4], further including a wavelength conversion layer that covers the reflection layer and the LED element, wherein the wavelength conversion layer includes a transparent resin and phosphor particles.
[6] The LED device according to any one of [1] to [5], wherein the light diffusion particles are composed of at least one type of inorganic particles selected from the group consisting of titanium oxide, barium sulfate, barium titanate, boron nitride, zinc oxide, and aluminum oxide.
[7] The LED device according to any one of [1] to [6], wherein the ceramic binder is a polymer of a trifunctional silane compound and a tetrafunctional silane compound, and a polymerization ratio of the trifunctional silane compound to the tetrafunctional silane compound is 3:7 to 7:3.
[8] The LED device according to any one of [1] to [6], wherein the ceramic binder is a polymer of a bifunctional silane compound and a trifunctional silane compound, and a polymerization ratio of the bifunctional silane compound to the trifunctional silane compound is 1:9 to 4:6.
[9] The LED device according to any one of [1] to [8], wherein the reflection layer further includes metal oxide microparticles having a mean primary particle diameter of 5 to 100 nm.
[10] The LED device according to [9], wherein the metal oxide microparticles are composed of at least one compound selected from the group consisting of zirconium oxide, titanium oxide, cerium oxide, niobium oxide, and zinc oxide.
[11] The LED device according to any one of [1] to [10], wherein the reflection layer further includes a cured product of a metal alkoxide or a metal chelate of a divalent or higher polyvalent metal element other than Si element.
[12] The LED device according to any one of [1] to [11], wherein the substrate has a metal part, and the LED device includes the reflection layer on the surface of the substrate outside the LED element-mounting area and on the metal part.
[13] The LED device according to any one of [1] to [11], wherein the substrate has a metal part, and the LED device includes the reflection layer on the surface of the substrate outside the LED element-mounting area and outside an area of the metal part.
   A second aspect of the present invention relates to methods of manufacturing an LED device set forth below.
[14] A method of manufacturing an LED device that includes a substrate, an LED element that is mounted on the substrate and configured to emit light of a specific wavelength, and a reflection layer that is formed on a surface of the substrate outside the LED element-mounting area, the method including:
   spray-applying a reflection layer-forming composition including light diffusion particles and an organic silicon compound to the surface of the substrate while protecting the LED element-mounting area with a mask to form the reflection layer.
[15] The method according to [14], wherein the substrate has a metal part, and the method includes forming the reflection layer on the surface of the substrate outside the LED element-mounting area and on the metal part, in the step of forming the reflection layer.
[16] The method according to [14], wherein the substrate has a metal part, and the method includes forming the reflection layer on the surface of the substrate outside the LED element-mounting area and outside an area of the metal part, in the step of forming the reflection layer.
[17] The method according to any one of [14] to [16], wherein the substrate has a cavity, and the method includes spray-applying the reflection layer-forming composition to an inner wall of the cavity.

### Advantageous Effects of Invention

According to the LED device of the present invention, a ceramic is employed as a binder of a reflection layer, and inorganic particles are employed as light diffusion particles. Therefore, the reflection layer is not easily deteriorated by heat, light or the like, making it possible to maintain good out-coupling efficiency over a long period of time.

### Brief Description of Drawings

FIG. 1 is a schematic sectional view illustrating an example of an LED device of the present invention;
FIG. 2 is a schematic sectional view illustrating another example of an LED device of the present invention;
FIG. 3 is a schematic sectional view illustrating another example of an LED device of the present invention;
FIG. 4 is a schematic sectional view illustrating another example of an LED device of the present invention;
FIG. 5 is a top view illustrating an example of a mask that protects an LED-mounting area in a method of manufacturing an LED device of the present invention;
FIG. 6 is a schematic sectional view illustrating an example of a sprayer that applies a reflection layer-forming composition in a method of manufacturing an LED device of the present invention;
FIG. 7 is a top view illustrating another example of a mask that protects an LED-mounting area in a method of manufacturing an LED device of the present invention;
FIG. 8A is a top view illustrating another example of an LED device of the present invention, and FIG. 8B is a schematic sectional view of the LED device;
FIG. 9 is a schematic sectional view illustrating another example of an LED device of the present invention;
FIGS. 10A to 10D are explanatory drawings for explaining a method of forming a reflection layer in a method of manufacturing an LED device of the present invention;
FIGS. 11A to 11C are explanatory drawings for explaining a method of forming a reflection layer in a method of manufacturing an LED device of the present invention; and
FIG. 12 is an explanatory drawing for explaining a method of forming a reflection layer in a method of manufacturing an LED device of the present invention;

### Description of Embodiments

### 1. LED Device

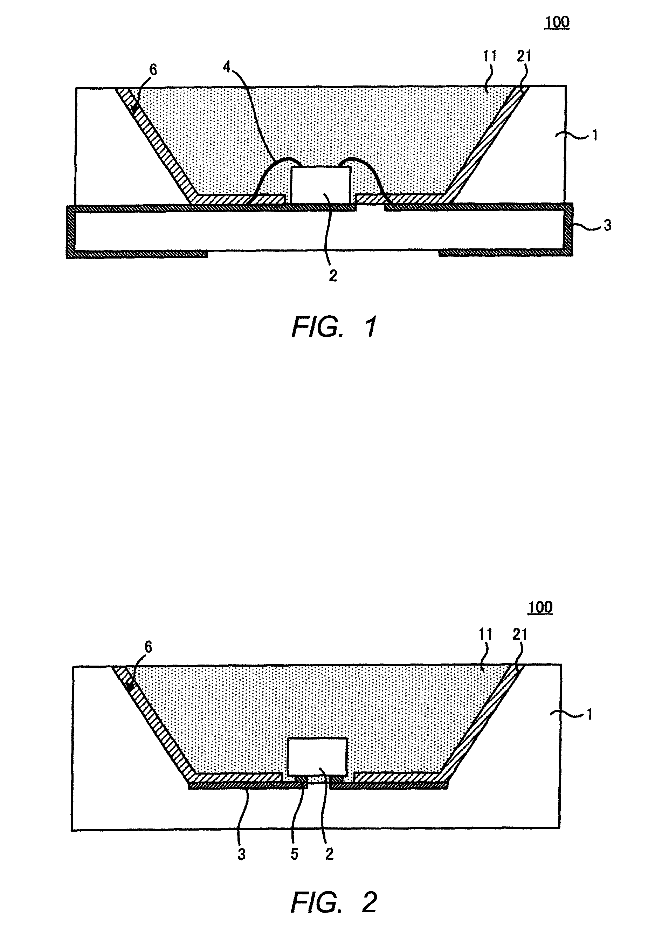

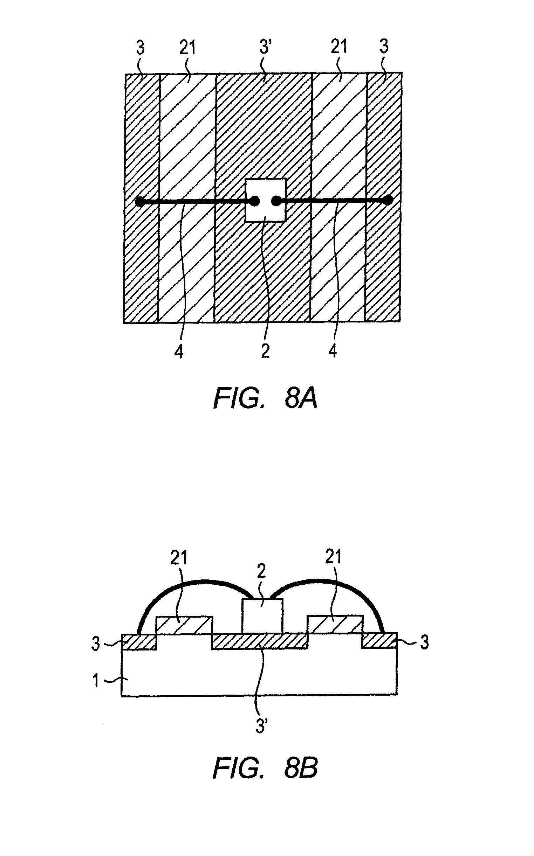

The LED device of the present invention relates to an LED device having a reflection layer that reflects an emission light or the like of an LED element toward the side of an out-coupling surface. Examples of the structure of the LED device of the present invention are illustrated in schematic sectional views of FIGS. 1 to 4, top view of FIG. 8A, and schematic sectional view of FIG. 8B. LED device 100 of the present invention has substrate 1, LED element 2 mounted on substrate 1, reflection layer 21 formed outside an LED element-mounting area of substrate 1, and wavelength conversion layer 11 that covers LED element 2 and reflection layer 21.

### (1) Substrate

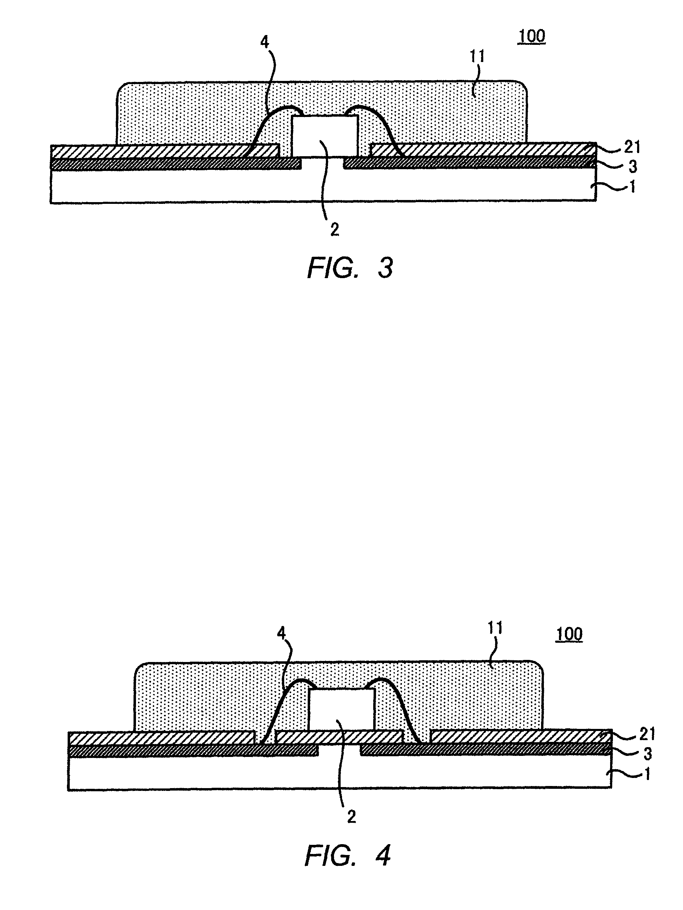

Substrate 1 in LED device 100 of the present invention may have a flat shape as illustrated in FIGS.3, 4 and 8B, and also has cavity (recess) as illustrated in FIGS. 1 and 2. The shape of the cavity is not particularly limited. For example, as illustrated in FIGS. 1 and 2, it may be frustum-shaped, prismoid-shaped, column-shaped, prism-shaped, or the like.

Substrate 1 preferably has an insulating property and heat resistance, and is preferably composed of a ceramic resin or a heat-resistant resin. Examples of the heat-resistant resin include liquid crystal polymers, polyphenylene sulfide, aromatic nylon, epoxy resins, hard silicone resins, and polyphthalic acid amide.

Substrate 1 may contain an inorganic filler. The inorganic filler can be titanium oxide, zinc oxide, alumina, silica, barium titanate, calcium phosphate, calcium carbonate, white carbon, talc, magnesium carbonate, boron nitride, glass fiber, or the like.

As illustrated, for example, in FIG. 8, metal part 3,3' is typically provided on substrate 1. Metal part 3,3' is composed of a metal such as silver. The metal part can be a pair of metal electrode parts (in FIG. 8, indicated by reference sign 3) that electrically connect an external electrode (not illustrated) and LED element 2. Metal part 3 may include a metal reflection film (in FIG. 8, indicated by reference sign 3') that surrounds LED element 2 and reflects light from LED element 2 toward the side of an out-coupling surface.

### (2) LED Element

LED element 22 is connected to metal part (metal interconnection) 3 provided on substrate 1, and is fixed on substrate 1.

As illustrated, for example, in FIG. 1, LED element 2 may be connected to metal part (metal electrode part) 3 provided on substrate 1 through interconnection 4. Further, as illustrated in FIG. 2, it may be connected to metal part (metal electrode part) 3 arranged on substrate 1 through bump electrode 5. The mode in which LED element 2 is connected to metal part (metal electrode part) 3 through interconnection 4 is called wire-bonding, and the mode in which LED element 2 is connected to metal part (metal electrode part) 3 through bump electrode 5 is called flip-chip bonding.

The wavelength of light emitted by LED element 2 is not particularly limited. LED element 2 may be an element that emanates, for example, blue light (light of about 420 to 485 nm wavelength), and maybe an element that emanates ultraviolet light.

The configuration of LED element 2 is not particularly limited. In a case where LED element 2 is an element that emanates blue light, LED element 2 can be a laminate of an n-GaN compound semiconductor layer (cladding layer), an InGaN compound semiconductor layer (light emitting layer), a p-GaN compound semiconductor layer (cladding layer), and a transparent electrode layer. LED element 2 can have an emission surface of 200 to 300 µm × 200 to 300 µm, for example. Further, LED element 2 typically has a height of about 50 to 200 µm. In LED device 100 as illustrated in FIGS. 1 to 4, only one LED element 2 is disposed on substrate 1, but a plurality of LED elements 2 may also be disposed on substrate 1.

### (3) Reflection Layer

Reflection layer 21 is a layer that reflects emission light from LED element 2 or fluorescence emanated by a phosphor contained in wavelength conversion layer 11 toward the side of an out-coupling surface of LED device 100. By providing reflection layer 21, the amount of light out-coupled from the out-coupling surface of LED device 100 is increased.

Reflection layer 21 is formed on the surface of substrate 1 in areas other than the mounting area of LED element 2. The mounting area of LED element 2 refers to an emission surface of LED element 2, and a connection portion between LED element 2 and metal part (metal electrode part) 3. That is, reflection part 21 is formed on an area not inhibiting the emission of light from LED element 2 and the connection between LED element 2 and metal part (metal electrode part) 3. As illustrated for example in FIG. 3, reflection layer 21 may be formed only on an area in the vicinity of LED element 2. Further, as illustrated for example in FIG. 4, reflection layer 21 may be formed not only on an area in the vicinity of LED element 2, but also between substrate 1 and LED element 2. When reflection layer 21 is formed also between substrate 1 and LED element 2, reflection layer 21 reflects light that goes around to the side of a back surface of LED element 2. Therefore, the efficiency of out-coupling light from LED device 100 is raised.

As illustrated in FIGS. 1 and 2, in a case where substrate 1 has a cavity, it is preferable that reflection layer 21 is formed also on cavity inner wall surface 6. When reflection layer 21 is formed on cavity inner wall surface 6, it becomes possible to out-couple light that propagates in a direction horizontal to the surface of wavelength conversion layer 11 by reflecting it at reflection layer 21.

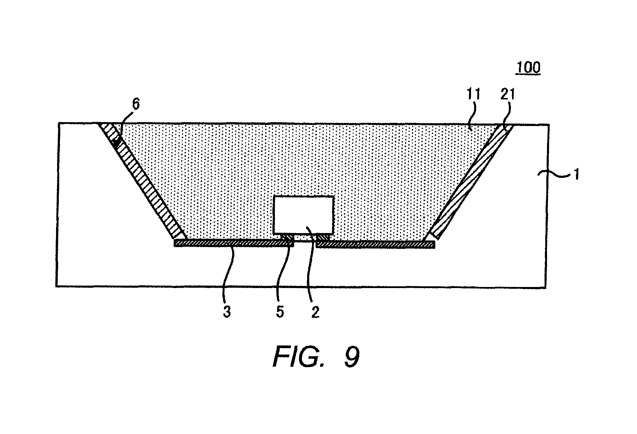

As illustrated in FIG. 1, reflection layer 21 may be formed on an area outside the mounting area of LED element 2 and on metal part 3. Further, as illustrated in FIG. 8, reflection layer 21 may also be formed on an area outside the mounting area of LED element 2 and outside the metal part area; that is, it may be formed only on an area outside the mounting area of LED element 2 and where metal part 3,3' is not formed. Specifically, as illustrated in FIG. 8, reflection layer 21 may be formed in a gap between metal electrode part 3 and metal reflection film 3'. In this case, light from LED element 2, or the like is reflected by metal part 3,3' and reflection layer 21. Further, as illustrated, for example, in FIG. 9, reflection layer 21 may be formed only on cavity inner wall surface 6 of substrate 1. Even in this case, light from LED element 2, or the like is reflected by metal part (metal electrode part) 3 and reflection layer 21.

A reflection layer of a conventional LED device has been generally a plated metal. However, a plated metal cannot be formed on the entire surface of a substrate for the prevention of electrical conduction. Therefore, there has been a problem in which, in an area where a plated metal is not formed, light results in being absorbed into the substrate. Other proposed reflection layers include those composed of a resin layer in which light diffusion particles are dispersed, but such reflection layers are susceptible to deterioration for example by emission light, heat from the LED element. Therefore, there has been a case where, if an LED device is used for a long period of time, the out-coupling efficiency of light from the LED device may be deteriorated due to degradation of the resin.

In contrast, reflection layer 21 of an LED device of the present invention is a layer in which light diffusion particles composed of inorganic particles are bound together with a ceramic binder (a cured product of an organic silicon compound); no electricity is conducted. That is, according to the LED device of the present invention, reflection layer 21 can be formed on any desired area of substrate 1; reflection layer 21 can be formed also in a gap between metal parts, for example. Accordingly, it is possible to out-couple light efficiently from the LED device. Further, reflection layer 21 of the LED device of the present invention is not easily decomposed even when heat or light from LED element 2 is received. Accordingly, the light reflectivity of reflection layer 21 does not vary over a long period of time, and thus good out-coupling efficiency is maintained for a long period of time.

The thickness of reflection layer 21 is preferably 5 to 200 µm. By setting the thickness of reflection layer 21 to 200 µm or less, it becomes possible to reduce cracks in reflection layer 21. On the other hand, when the thickness of reflection layer 21 is set to 5 µm or more, it becomes possible to sufficiently secure light reflectivity of reflection layer 21, allowing out-coupling efficiency to be raised. Further, the thickness of reflection layer 21 can also be set to 5 to 30 µm.

The mean reflectance of visible light (450 to 700 nm wavelength) at the time when the thickness of reflection layer 21 is set to 30 µm is preferably 60% or more, and more preferably 75% or more. When the mean reflectance at the aforementioned thickness is 60% or more, the out-coupling efficiency from an LED device is likely to be raised. The reflectance of reflection layer 21 is measured with a spectrophotometer. Examples of the spectrophotometer include spectrophotometer V-670, available from JASCO Corporation.

Reflectance is measured as follows. A standard reflection plate (Spectralon reflection plate available from Labsphere, Inc) is installed on an integrating sphere unit. Then, the reflectance of the standard reflection plate is measured with a spectrophotometer. On the other hand, a sample of a 30 µm-thick reflection layer formed on a glass substrate is provided. Then, the reflectance of this sample is measured in the same manner; and the ratio of the reflectance of the sample relative to the reflectance of the standard reflection plate is set as the reflection of the reflection layer.

### (3-1) Ceramic Binder

Reflection layer 21 includes a ceramic binder (hereinafter, also referred to as "binder"). The ceramic binder can be (i) a cured product of a polysilazane oligomer, and (ii) polysiloxane which is a cured product of a monomer or an oligomer of a silane compound.

The amount of the binder contained in reflection layer 21 is preferably 5 to 40 mass% based on the total mass of the reflection layer, and more preferably 10 to 30 mass%. When the amount of the binder is less than 5 mass%, the strength of a film may not be sufficient. On the other hand, when the content of the binder exceeds 40 mass%, the amount of light diffusion particles is relatively decreased. Therefore, the light reflectivity of the reflection layer may fail to be sufficient.

The binder can be (i) a polymerization product (cured product) of a polysilazane oligomer represented by the general formula (I): (R¹R²SiNR³)ₙ. In the general formula (I), R¹, R² and R³ each independently represent a hydrogen atom or an alkyl group, an aryl group, a vinyl group, or a cycloalkyl group, with at least one of R¹, R² and R³ being a hydrogen atom, and preferably all of them being a hydrogen atom. n represents an integer of 1 to 60. The molecular shape of a polysilazane oligomer may be any shape, and for example may be a linear shape or a cyclic shape.

A cured product of polysilazane can be obtained by subjecting a polysilazane oligomer represented by the aforementioned formula (I) to heating, excimer light treatment, UV light treatment, or the like in the presence of, where necessary, a reaction accelerator, and a solvent.

The binder can be (ii) polysiloxane which is a polymer (cured product) of a monomer or an oligomer of a bifunctional silane compound, a trifunctional silane compound, and/or a tetrafunctional silane compound.

Polysiloxane can be, for example, a polymer of a monomer or an oligomer of a trifunctional silane compound and a tetrafunctional silane compound. The polymerization ratio of a trifunctional silane compound to a tetrafunctional silane compound is preferably 3:7 to 7:3, and more preferably 4:6 to 6:4. When the polymerization ratio is the aforementioned ratio, the crosslinking degree of polysiloxane is not raised excessively, causing a crack to easily occur in a reflection layer. On the other hand, an organic group derived from a trifunctional silane compound does not remain in a large amount, causing reflection layer 21 not to easily repel a composition for forming wavelength conversion layer 11, and thus adhesion between reflection layer 21 and wavelength conversion layer 11 is likely to be raised.

Further, polysiloxane can be a polymer of a monomer or an oligomer of a bifunctional silane compound and a trifunctional silane compound. The polymerization ratio of a bifunctional silane compound to a trifunctional silane compound is preferably 1:9 to 4:6, and preferably 1:9 to 3:7. When the polymerization ratio is the aforementioned ratio, an organic group derived from a bifunctional silane compound does not remain in a large amount, causing reflection layer 21 not to easily repel a composition for forming wavelength conversion layer 11, and thus adhesion between reflection layer 21 and wavelength conversion layer 11 is likely to be raised.

Furthermore, polysiloxane can be a polymer of a monomer or an oligomer of a bifunctional silane compound, a trifunctional silane compound, and a tetrafunctional silane compound. The polymerization ratio of bifunctional silane compounds is preferably 3 to 30 (mol) when the total amount (mol) of a bifunctional silane compound, a trifunctional silane compound, and a tetrafunctional silane compound is set as 100. The polymerization ratio of trifunctional silane compounds is preferably 40 to 80 (mol) when the total amount (mol) of a bifunctional silane compound, a trifunctional silane compound, and a tetrafunctional silane compound is set as 100. The polymerization ratio of tetrafunctional silane compounds is preferably 10 to 30 (mol) when the total amount (mol) of a bifunctional silane compound, a trifunctional silane compound, and a tetrafunctional silane compound is set as 100.

Examples of a tetrafunctional silane compound include a compound represented by the following general formula (II):

Si(OR⁴)₄ (II).

where R⁴ each independently represents an alkyl group or a phenyl group, and preferably represents an alkyl group having 1 to 5 carbon atoms, or a phenyl group.

Specific examples of the tetrafunctional silane compounds include: alkoxysilanes, or aryloxysilanes, such as tetramethoxysilane, tetraethoxysilane, tetrapropoxysilane, tetrabutoxysilane, tetrapentyloxysilane, tetraphenyoxysilane, trimethoxymonoethoxysilane, dimethoxydiethoxysilane, triethoxymonomethoxysilane, trimethoxymonopropoxysilane, monomethoxytributoxysilane, monomethoxytripentyloxysilane, monomethoxytriphenyloxysilane, dimethoxydipropoxysilane, tripropoxymonomethoxysilane, trimethoxymonobutoxysilane, dimethoxydibutoxysilane, triethoxymonopropoxysilane, diethoxydipropoxysilane, tributoxymonopropoxysilane, dimethoxymonoethoxymonobutoxysilane, diethoxymonomethoxymonobutoxysilane, diethoxymonopropoxymonobutoxysilane, dipropoxymonomethoxymonoethoxysilane, dipropoxymonomethoxymonobutoxysilane, dipropoxymonoethoxymonobutoxysilane, dibutoxymonomethoxymonoethoxysilane, dibutoxymonoethoxymonopropoxysilane, and monomethoxymonoethoxymonopropoxymonobutoxysilane. Among these, tetramethoxysilane and tetraethoxysilane are preferable.

Examples of a trifunctional silane compound include a compound represented by the following general formula (III) :

R⁵Si(OR⁶)₃ (III).

where R⁵ each independently represents an alkyl group or a phenyl group, and preferably represents an alkyl group having 1 to 5 carbon atoms, or a phenyl group. Further, R⁶ represents a hydrogen atom or an alkyl group.

Specific examples of the trifunctional silane compounds include: monohydrosilane compounds such as trimethoxysilane, triethoxysilane, tripropoxysilane, tripentyloxysilane, triphenyloxysilane, dimethoxymonoethoxysilane, diethoxymonomethoxysilane, dipropoxymonomethoxysilane, dipropoxymonoethoxysilane, dipentyloxylmonomethoxysilane, dipentyloxymonoethoxysilane, dipentyloxymonopropoxysilane, diphenyloxylmonomethoxysilane, diphenyloxymonoethoxysilane, diphenyloxymonopropoxysilane, methoxyethoxypropoxysilane, monopropoxydimethoxysilane, monopropoxydiethoxysilane, monobutoxydimethoxysilane, monopentyloxydiethoxysilane, and monophenyloxydiethoxysilane; monomethylsilane compounds such as methyltrimethoxysilane, methyltriethoxysilane, methyltripropoxysilane, methyltripentyloxysilane, methylmonomethoxydiethoxysilane, methylmonomethoxydipropoxysilane, methylmonomethoxydipentyloxysilane, methylmonomethoxydiphenyloxysilane, methylmethoxyethoxypropoxysilane, and methylmonomethoxymonoethoxymonobutoxysilane; monoethylsilane compounds such as ethyltrimethoxysilane, ethyltripropoxysilane, ethyltripentyloxysilane, ethyltriphenyloxysilane, ethylmonomethoxydiethoxysilane, ethylmonomethoxydipropoxysilane, ethylmonomethoxydipentyloxysilane, ethylmonomethoxydiphenyloxysilane, and ethylmonomethoxymonoethoxymonobutoxysilane; monopropylsilane compounds such as propyltrimethoxysilane, propyltriethoxysilane, propyltripentyloxysilane, propyltriphenyloxysilane, propylmonomethoxydiethoxysilane, propylmonomethoxydipropoxysilane, propylmonomethoxydipentyloxysilane, propylmonomethoxydiphenyloxysilane, propylmethoxyethoxypropoxysilane, and propylmonomethoxymonoethoxymonobutoxysilane; and monobutylsilane compounds such as butyltrimethoxysilane, butyltriethoxysilane, butyltripropoxysilane, butyltripentyloxysilane, butyltriphenyloxysilane, butylmonomethoxydiethoxysilane, butylmonomethoxydipropoxysilane, butylmonomethoxydipentyloxysilane, butylmonomethoxydiphenyloxysilane, butylmethoxyethoxypropoxysilane, and butylmonomethoxymonoethoxymonobutoxysilane.

When R⁵ in the general formula (III) that represents a trifunctional silane compound is a methyl group, the hydrophobicity of a surface of reflection layer 21 is lowered. Thereby, a composition for forming wavelength conversion layer 11 is sufficiently wet and spread, allowing adhesion between wavelength conversion layer 11 and reflection layer 21 to be raised. Examples of a trifunctional compound represented by general formula (III) in which R⁵ is a methyl group include methyltrimethoxysilane and methyltriethoxysilane, with methyltrimethoxysilane being particularly preferable.

Examples of a bifunctional silane compound include a compound represented by the following general formula (IV) :

R⁷₂Si(OR⁸)₂ (IV).

where R⁷ each independently represents an alkyl group or a phenyl group, and preferably represents an alkyl group having 1 to 5 carbon atoms, or a phenyl group. Further, R⁸ represents a hydrogen atom or an alkyl group.

Specific examples of the bifunctional silane compounds include: dimethoxysilane, diethoxysilane, dipropoxysilane, dipentyloxysilane, diphenyloxysilane, methoxyethoxysilane, methoxypropoxysilane, methoxypentyloxysilane, methoxyphenyloxysilane, ethoxypropoxysilane, ethoxypentyloxysilane, ethoxyphenyloxysilane, methyldimethoxysilane, methylmethoxyethoxysilane, methyldiethoxysilane, methylmethoxypropoxysilane, methylmethoxypentyloxysilane, methylmethoxyphenyloxysilane, ethyldipropoxysilane, ethylmethoxypropoxysilane, ethyldipentyloxysilane, ethyldiphenyloxysilane, propyldimethoxysilane, propylmethoxyethoxysilane, propylethoxypropoxysilane, propyldiethoxysilane, propyldipentyloxysilane, propyldiphenyloxysilane, butyldimethoxysilane, butylmethoxyethoxysilane, butyldiethoxysilane, butylethoxypropoxysilane, butyldipropoxysilane, butylmethyldipentyloxysilane, butylmethyldiphenyloxysilane, dimethyldimethoxysilane, dimethylmethoxyethoxysilane, dimethyldiethoxysilane, dimethyldipentyloxysilane, dimethyldiphenyloxysilane, dimethylethoxypropoxysilane, dimethyldipropoxysilane, diethyldimethoxysilane, diethylmethoxypropoxysilane, diethyldiethoxysilane, diethylethoxypropoxysilane, dipropyldimethoxysilane, dipropyldiethoxysilane, dipropyldipentyloxysilane, dipropyldiphenyloxysilane, dibutyldimethoxysilane, dibutyldiethoxysilane, dibutyldipropoxysilane, dibutylmethoxypentyloxysilane, dibutylmethoxyphenyloxysilane, methylethyldimethoxysilane, methylethyldiethoxysilane, methylethyldipropoxysilane, methylethyldipentyloxysilane, methylethyldiphenyloxysilane, methylpropyldimethoxysilane, methylpropyldiethoxysilane, methylbutyldimethoxysilane, methylbutyldiethoxysilane, methylbutyldipropoxysilane, methylethylethoxypropoxysilane, ethylpropyldimethoxysilane, ethylpropylmethoxyethoxysilane, dipropyldimethoxysilane, dipropylmethoxyethoxysilane, propylbutyldimethoxysilane, propylbutyldiethoxysilane, dibutylmethoxyethoxysilane, dibutylmethoxypropoxysilane, and dibutylethoxypropoxysilane. Among these, dimethoxysilane, diethoxysilane, methyldimethoxysilane, and methyldiethoxysilane are preferable.

Polysiloxane can be obtained by subjecting a monomer or an oligomer of the aforementioned silane compound to heat treatment, or the like in the presence of, where necessary, an acid catalyst, water, and a solvent.

### (3-2) Light Diffusion Particles

Light diffusion particles contained in a reflection layer are not particularly limited as long as they are inorganic particles having high light diffusibility. The total reflectance of light diffusion particles is preferably 80% or higher, and more preferably 90% or higher. The total reflectance can be measured with Hitachi Spectrophotometer U4100 available from Hitachi High-Tech Co., Ltd.

Examples of inorganic particle which can be light diffusion particles include zinc oxide (ZnO), barium titanate (BaTiO₃), barium sulfate (BaSO₄), titanium dioxide (TiO₂), boron nitride (BrN), magnesium oxide (MgO), calcium carbonate (CaCO₃), aluminum oxide (Al₂O₃), barium sulfate (BaO), and zirconium oxide (ZrO₂). Examples of preferable light diffusion particles include one or more types selected from the group consisting of titanium oxide, barium sulfate, barium titanate, boron nitride, zinc oxide, and aluminum oxide. These particles have a large total reflectance and are easy to be handled. Reflection layer 21 may contain only one type of light diffusion particles, and may also contain two or more types thereof.

The mean primary particle diameter of the light diffusion particles is preferably greater than 100 nm and 20 µm or less, more preferably greater than 100 nm and 10 µm or less, and still more preferably 200 nm to 2.5 µm. The mean primary particle diameter as used herein refers to a value of D50 measured with a laser diffraction particle size distribution analyzer. Examples of the laser diffraction particle size distribution analyzer include a laser diffraction particle size distribution analyzer available from Shimadzu Corporation.

The amount of the light diffusion particles contained in reflection layer 21 is preferably 60 to 95 mass% based on the total mass of the reflection layer, and more preferably 70 to 90 mass%. When the amount of light diffusion particles is less than 60 mass%, the light reflectivity of the reflection layer fails to be sufficient, and thus the out-coupling efficiency may not be raised. On the other hand, when the content of light diffusion particles exceeds 95 mass%, the amount of a binder is relatively decreased, and thus the strength of the reflection layer may be lowered.

### (3-3) Metal Oxide Microparticles

Reflection layer 21 may contain metal oxide microparticles. When reflection layer 21 contains metal oxide microparticles, fine irregularities occur on the surface of reflection layer 21. Due to the irregularities, an anchor effect occurs between reflection layer 21 and wavelength conversion layer 11, allowing adhesion between reflection layer 21 and wavelength conversion layer 11 to be raised. Further, since the gap between light diffusion particles contained reflection layer 21 is filled, the strength of reflection layer 21 is raised, making it difficult for a crack to occur in reflection layer 21.

Although the types of the metal oxide micriparticles are not particularly limited, at least one type selected from the group consisting of zirconium oxide, titanium oxide, cerium oxide, niobium oxide, and zinc oxide is preferable. In particular, from the viewpoint of increased film strength, it is preferable that zirconium oxide microparticles are contained. Reflection layer 21 may contain only one type of metal oxide microparticles, and may contain two or more types thereof.

The metal oxide microparticles may be those the surface of which is treated with a silane coupling agent or a titanium coupling agent. When the surface of the metal oxide microparticles is treated, the metal oxide microparticles are easily dispersed uniformly in reflection layer 21.

The mean primary particle diameter of the metal oxide microparticles is 5 to 100 nm, preferably 5 to 80 nm, and more preferably 5 to 50 nm. When the mean primary particle diameter of the metal oxide microparticles is 100 nm or less, the metal oxide microparticles are likely to enter a gap between light diffusion particles, allowing the strength of the reflection layer to be raised. Further, when the mean primary particle diameter of the metal oxide microparticles is 5 nm or more, adequate irregularities are likely to be formed on the surface of reflection layer 21, allowing the aforementioned anchor effect to be easily obtained.

The amount of the metal oxide microparticles contained in reflection layer 21 is preferably 0.5 to 30 mass% based on the total mass of the reflection layer, more preferably 0.5 to 20 mass%, still more preferably 1 to 10 mass%, and even still more preferably 2 to 10 mass%. When the content of the metal oxide microparticles is less than 0.5 mass%, the anchor effect at the interface between reflection layer 21 and wavelength conversion layer 11 and the strength of the film are not sufficiently raised. On the other hand, when the content of the metal oxide microparticles exceeds 30 mass%, the amount of the binder is relatively decreased, and thus there is a risk that the film strength may be lowered.

### (3-4) Cured Product of Metal Alkoxide or Metal Chelate

Reflection layer 21 may contain a cured product of a metal alkoxide or a metal chelate of a divalent or a higher polyvalent metal element other than Si element. When reflection layer 21 contains a cured product of a metal alkoxide or a metal chelate, the adhesion between reflection layer 21 and substrate 1 is raised. The metal contained in the metal alkoxide or the metal chelate forms a metalloxane bonding with a hydroxyl group on the surface of substrate 1, and thus the adhesion between reflection layer 21 and substrate 1 is raised.

The amount of the metal element (excluding Si element) derived from the metal alkoxide or the metal chelate contained in reflection layer 21 is preferably 0.5 to 20 mol% based on the mole number of Si element contained in reflection layer 21, and more preferably 1 to 10 mol%. When the amount of the metal element is less than 0.5 mol%, the adhesion between reflection layer 21 and substrate 1 is not raised. On the other hand, when the amount of a cured product of a metal alkoxide or a metal chelate is increased, the amount of the light diffusion particles is relatively decreased, and thus there is a risk that light reflectivity of the reflection layer may be lowered. The amount of the metal element and the amount of Si element can be calculated by energy dispersive x-ray spectrometry (EDX).

Although the types of a metal element contained in a metal alkoxide or a metal chelate are not particularly limited as long as the metal element is a divalent or higher polyvalent metal element (excluding Si), an element of group 4 or group 13 is preferable. That is, specifically, the metal alkoxide or the metal chelate is preferably a compound represented by the following general formula (V):

M^{m}XₙYₘ₋ₙ (V).

where M represents a metal element of group 4 or group 13, and m represents the valence number (3 or 4) of M. X represents a hydrolyzable group, and n represents the number (an integer of 2 or more and 4 or less) of X group, provided that m≥n. Y represents a monovalent organic group.

In the general formula (V), a metal element of group 4 or group 13 represented by M is preferably aluminum, zirconium, or titanium, and particularly preferably zirconium. A cured product of an alkoxide or a chelate containing zirconium element does not have an absorption wavelength at a general light emission wavelength region (in particular, blue light (420-485 wavelength)) of LED element 2. Therefore, light or the like from LED element 2 is not easily absorbed into a cured product of an alkoxide or a chelate of zirconium.

In the general formula (V), the hydrolyzable group represented by X can be a group that is hydrolyzed with water to form a hydroxyl group. Preferable examples of the hydrolyzable group include a lower alkoxy group having 1 to 5 carbon atoms, acetoxy group, butanoxime group, and chloro group. In the general formula (V), all of groups represented by X may be the same or different.

The hydrolyzable group represented by X is, as mentioned above, hydrolyzed at the time when a metal element forms a metalloxane bonding with a hydroxyl group, or the like on the surface of substrate 1. Therefore, such a group as to produce a compound, after hydrolysis, which is neutral and has a light boiling point is preferable. Thus, the group represented by X is preferably an alkoxy group having 1 to 5 carbon atoms, and more preferably a methoxy group or an ethoxy group.

In the general formula (V), the monovalent organic group represented by Y may be a monovalent organic group contained in a general silane coupling agent. Specifically, the monovalent organic group can be an aliphatic group, an alicyclic group, an aromatic group, or an alicyclic aromatic group having 1 to 1,000, preferably 500 or less, more preferably 100 or less, still more preferably 40 or less, and even still more preferably 6 or less carbon atoms. The organic group represented by Y may be a group in which an aliphatic group, an alicyclic group, an aromatic group, and an alicyclic aromatic group are linked via a linking group. The linking group may be an atom such as O, N and S, or an atomic group containing these atoms.

The organic group represented by Y may have a substituent. Examples of the substituent include: halogen atoms such as F, Cl, Br and I; and organic groups such as vinyl group, methacryloxy group, acryloxy group, styryl group, mercapto group, epoxy group, epoxycyclohexyl group, glycidoxy group, amino group, cyano group, nitro group, sulfonate group, carboxy group, hydroxy group, acyl group, alkoxy group, imino group, and phenyl group.

Specific examples of a metal alkoxide or metal chelate containing aluminum element represented by the general formula (V) include aluminum triisopropoxide, aluminum tri-n-butoxide, aluminum tri-t-butoxide, and aluminum triethoxide.

Specific examples of a metal alkoxide or metal chelate containing zirconium element represented by the general formula (V) include zirconium tetramethoxide, zirconium tetraethoxide, zirconium tetra-n-propoxide, zirconium tetra-i-propoxide, zirconium tetra-n-butoxide, zirconium tetra-i-butoxide, zirconium tetra-t-butoxide, zirconium dimethacrylate dibutoxide, and dibutoxy zirconium bis(ethyl acetoacetate).

Specific examples of a metal alkoxide or metal chelate containing titanium element represented by the general formula (V) include titanium tetraisopropoxide, titanium tetra-n-butoxide, titanium tetra-i-butoxide, titanium methacrylate triisopropoxide, titanium tetramethoxypropoxide, titanium tetra-n-propoxide, titanium tetraethoxide, titanium lactate, titanium bis(ethyl hexoxy)bis(2-ethyl-3-hydroxyhexoxide), and titanium acetylacetonate.

It is to be noted that the metal alkoxides or metal chelates listed above are part of readily available commercial organic metal alkoxides or metal chelates. The cured products of metal alkoxides or metal chelates listed in a table regarding coupling agents and relevant products in Chapter 9 of "Kappuringu-zai Saiteki Riyou Gijyutsu (Technology of Optimal Use of Coupling Agent)" published by National Institute of Advanced Science and Technology can also be applied to the present invention.

### (4) Wavelength Conversion Layer

In LED device 100 of the present invention, there may be formed wavelength conversion layer 11 in which phosphor particles are dispersed in a transparent resin. Wavelength conversion layer 11 is typically formed so as to cover LED element 2 and reflection layer 21. Wavelength conversion layer 11 emanates fluorescence upon receipt of light (excitation light) emitted by LED element 2. Mixing of the excitation light and fluorescence allows the color of light from LED device 100 to be a desired color. For example, when light from LED element 2 is blue and fluorescence emanated by a phosphor contained in wavelength conversion layer 11 is yellow, light from LED device 100 becomes white.

The transparent resin contained in wavelength conversion layer 11 is not particularly limited, and can be, for example, a silicone resin, or an epoxy resin.

It is sufficient that the phosphor particles contained in wavelength conversion layer 11 are excited by light emitted by LED element 2 to emanate fluorescence having a wavelength that is different from that of emission light from LED element 2. For example, examples of the phosphor particles that emanate yellow fluorescence include YAG (yttrium-aluminum-garnet) phosphor. The YAG phosphor emanates yellow fluorescence (550 to 650 nm wavelength) upon receipt of blue light (420 to 485 nm wavelength) emitted by a blue LED element.

The phosphor particles can be produced for example by the methods including: 1) mixing an appropriate amount of flux (fluoride such as ammonium fluoride) with a mixed raw material having a predetermined composition followed by pressing to produce a molded article; and 2) loading the resulting molded article into a crucible followed by calcination in air at 1,350 to 1,450°C for 2 to 5 hours to produce a sintered product.

The mixed raw material having a predetermined composition can be produced by fully mixing stoichiometric ratios of oxides of Y, Gd, Ce, Sm, Al, La and Ga or compounds that are easily converted to the oxides at elevated temperatures. Alternatively, the mixed raw material having a predetermined composition can also be produced by the methods including: 1) mixing a solution containing stoichiometric ratios of the rare earth elements Y, Gd, Ce and Sm in acid with oxalic acid to obtain a coprecipitate oxide; and 2) mixing the coprecipitate oxide with aluminum oxide or gallium oxide.

The types of the phosphor are not limited to YAG phosphor; for example, other phosphors, including Ce-free, non-garnet phosphor, can also be available.

The mean particle diameter of the phosphor particles is preferably 1 to 50 µm, and is more preferably 10 µm or less. The larger the particle diameter of the phosphor particles is, the higher luminescence efficiency (wavelength conversion efficiency) becomes. On the other hand, when the particle diameter of the phosphor particles is too large, the gap that occurs at the interface between phosphor particles and a transparent resin (epoxy resin or silicone resin) becomes larger. Thereby, the strength of a cured film of the wavelength conversion layer is likely to be lowered, or a gas is likely to intrude into the side of LED element 2 from the outside of the LED device. The mean particle diameter of the phosphor particles can be measured, for example, by Coulter counter method.

The amount of the phosphor particles contained in wavelength conversion layer 11 is generally 5 to 15 mass% based on the total mass of the solid content of the wavelength conversion layer. The thickness of the wavelength conversion layer is generally 25 µm to 5 mm.

Wavelength conversion layer 11 can be obtained by providing a wavelength conversion layer-forming composition in which phosphor particles are dispersed in a transparent resin, and applying the composition onto LED element 2 and reflection layer 21 with a dispenser, followed by curing of the wavelength conversion layer-forming composition.

### 2. Method of Manufacturing LED Device

The method of manufacturing the LED device of the present invention includes: (1) first mode of forming reflection layer 21 after mounting LED element 2 (a method of manufacturing an LED device as illustrated, for example, in FIGS. 1 to 3, and 8); and (2) second mode of forming reflection layer 21 before mounting LED element 2 (a method of manufacturing an LED device as illustrated for example in FIG. 4).

### (1) First Mode

In the case of forming reflection layer 21 after mounting LED element 2, the method of manufacturing an LED device includes the following three steps:
1) mounting an LED element on a substrate;
2) applying a reflection layer-forming composition onto the substrate followed by curing; and
3) forming a wavelength conversion layer so as to cover a reflection layer and the LED element.

In the present mode, reflection layer 21 is formed after LED element 2 is mounted on substrate 1. Therefore, a reflection layer-forming composition is applied such that the reflection layer-forming composition does not adhere onto the emission surface of LED element 2. At that time, the reflection layer-forming composition may be applied while avoiding not only the emission surface of the LED element, but also a metal part area of substrate 1.

### · Step 1)

Metal part (metal electrode part) 3 provided on substrate 1 and LED element 2 are connected to each other, and LED element 2 is fixed on substrate 1. LED element 2 and Metal part (metal electrode part) 3 may be connected to each other through interconnection 4 as illustrated in FIG. 1, or may be connected to each other through bump electrode 5 as illustrated in FIG. 2.

### · Step 2)

A reflection layer-forming composition is applied such that the reflection layer-forming composition does not adhere to the emission surface of LED element 2 mounted in step 1) or to the surface of metal part 3,3', followed by curing. The methods of applying/curing the reflection layer-forming composition include the following two methods:
(i) applying a reflection layer-forming composition onto substrate 1 while protecting the emission surface of LED element 2 or metal part 3,3', followed by curing; and
(ii) applying a reflection layer-forming composition only to a desired area without protecting the emission surface of LED element 2 or metal part 3,3', followed by curing.

In either method, the reflection layer-forming composition to be applied to substrate 1 includes a precursor of the aforementioned ceramic binder (organic silicon compound), light diffusion particles, metal oxide microparticles, a metal alkoxide or a metal chelate, a solvent, and the like.

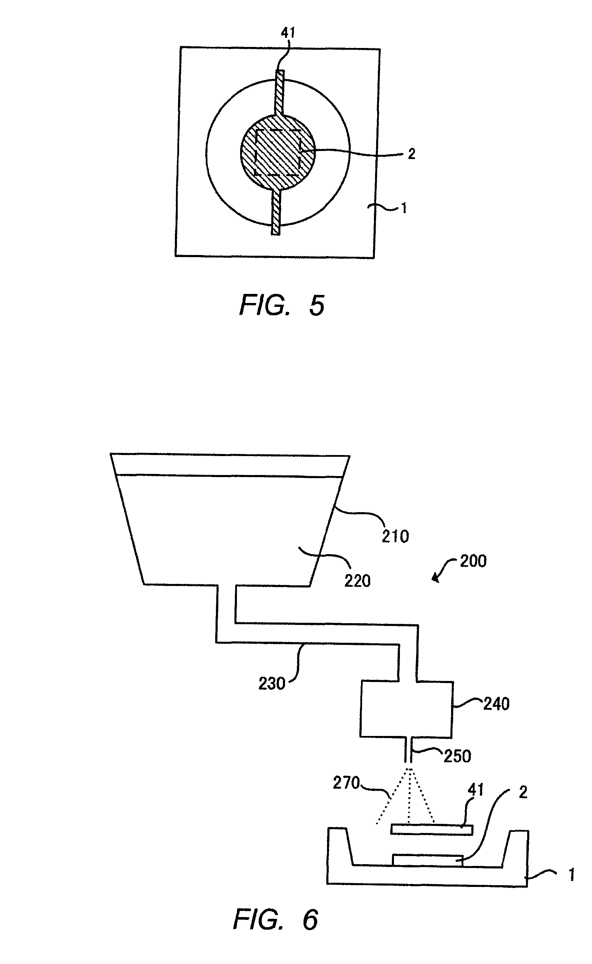

In the method of (i), an area where a reflection layer is not formed, i.e., the emission surface of LED element 2, metal part 3,3', or the like is protected. The protection method is not particularly limited; as illustrated in FIG. 5, the emission surface of LED element 2 or metal part 3,3' may be covered with plate-like mask 41, for example. Further, a cap may be disposed on substrate 1 so as to cover LED element 2 or metal part 3,3'.

After protecting a desired area with a mask or the like, a reflection layer-forming composition is applied onto substrate 1. The means for applying the reflection layer-forming composition is not particularly limited, and can be, for example, dispenser application method, or spray application method. When the application means is spray application, it is possible to form reflection layer 21 with smaller thickness. Further, in a case where substrate 1 has a cavity, it is easier to apply a reflection layer-forming composition to inner wall surface 6 of the cavity.

After application of the reflection layer-forming composition to substrate 1, the reflection layer-forming composition is dried and cured. The temperature at the time when the reflection layer-forming composition is dried and cured is preferably 20 to 200°C, and more preferably 25 to 150°C. When the temperature is below 20°C, there is a possibility that a solvent may not be volatilized sufficiently. On the other hand, when the temperature exceeds 200°C, there is a possibility that LED element 2 may be adversely affected. Further, from the viewpoint of production efficiency, the time for drying and curing is preferably 0.1 to 30 minutes, and more preferably 0.1 to 15 minutes. In a case where the organic silicon compound is a polysilazane oligomer, further heating and curing are carried out after irradiating a coating film with a VUV radiation (e.g., excimer light) in a range of a wavelength of 170 to 230 nm followed by curing, thereby forming a denser film. After curing the reflection layer-forming composition, plate-like mask 41 and a cap are removed.

In the method of (ii), a reflection layer-forming composition is applied only to a desired area without protecting the emission surface of LED element 2 or metal part 3,3'. The means of applying the reflection layer-forming composition is not particularly limited, and can be, for example, dispenser application method, or inkjet application method. After application of the reflection layer-forming composition, the reflection layer-forming composition is dried and cured in the same manner as in the method of (i).

In a case where the organic silicon compound contained in the reflection layer-forming composition is a polysilazane oligomer, it is preferable that the concentration of the polysilazane oligomer in the reflection layer-forming composition is higher. However, when the concentration thereof is too high, the storage stability of the reflection layer-forming composition is lowered. Therefore, the amount of the polysilazane oligomer is preferably 5 to 50 mass% based on the total mass of the reflection layer-forming composition.

Further, in a case where the organic silicon compound contained in the reflection layer-forming composition is a monomer or an oligomer of a silane compound, the amount of the monomer or oligomer of a silane compound contained in the reflection layer-forming composition is also preferably 5 to 50 mass% based on the total mass of the reflection layer-forming composition. It is to be noted that a method of preparing an oligomer of a silane compound is described later.

The amount of light diffusion particles contained in the reflection layer-forming composition is 60 to 95 mass% based on the total mass of the solid content of the reflection layer-forming composition, and more preferably 70 to 90 mass%. When the amount of light diffusion particles is less than 60 mass%, the light reflectivity of reflection layer 21 to be obtained may be insufficient. On the other hand, when the amount of light diffusion particles exceeds 95 mass%, the amount of a binder is relatively decreased in reflection layer 21 to be obtained, and thus the strength of reflection layer 21 may be lowered.

The amount of metal oxide microparticles contained in the reflection layer-forming composition is preferably 0.5 to 30 mass% based on the total mass of the solid content of the reflection layer-forming composition, more preferably 0.5 to 20 mass%, and still more preferably 1 to 10 mass%. When the amount of metal oxide microparticles exceeds 30 mass%, the amount of a binder is relatively decreased in reflection layer 21 to be obtained, and thus the strength of reflection layer 21 may be lowered.

The amount of a metal alkoxide or a metal chelate contained in the reflection layer-forming composition is preferably 1 to 30 mass% based on the total mass of the solid content of the reflection layer-forming composition, more preferably 1.5 to 20 mass%, and still more preferably 1.5 to 15 mass%. When the amount of the metal alkoxide or metal chelate is less than 1 mass%, the adhesion between reflection layer 21 to be obtained and substrate 1 is not easily increased. On the other hand, when the amount of a cured product of the metal alkoxide or metal chelate exceeds 30 mass%, the amount of a binder component is relatively lowered in reflection layer 21 to be obtained, and thus the strength thereof may be lowered.

The solvent contained in the reflection layer-forming composition is not particularly limited as long as it is capable of dissolving or dispersing an organic silicon compound. For example, the solvent may be an aqueous solvent excellent in compatibility with water, or may be a non-aqueous solvent having less compatibility with water.

In a case where the organic silicon compound contained in the reflection layer-forming composition is a polysilazane oligomer, the solvent can be an aliphatic hydrocarbon, an aromatic hydrocarbon, a halogen hydrocarbon, an ether, or an ester. Specific examples thereof include methyl ethyl ketone, tetrahydrofuran, benzene, toluene, xylene, dimethyl fluoride, chloroform, carbon tetrachloride, ethyl ether, isopropyl ether, dibutyl ether, and ethylbutyl ether.

On the other hand, in a case where the organic silicon compound contained in the reflection layer-forming composition is a monomer or an oligomer of a silane compound, the solvent is not particularly limited, and is preferably an alcohol, and particularly preferably a polyvalent alcohol. When an alcohol is contained in the reflection layer-forming composition, the viscosity of the reflection layer-forming composition is raised, allowing the precipitation of light diffusion particles to be suppressed. Examples of the polyvalent alcohol include ethylene glycol, propylene glycol, diethylene glycol, glycerin, 1,3-butanediol, and 1,4-butanediol, with ethylene glycol, propylene glycol, 1,3-butanediol, or 1,4-butanediol being particularly preferable.

Even in a case where the organic silicon compound contained in the reflection layer-forming composition is any of those mentioned above, the solvent contained in the reflection layer-forming composition preferably has a boiling point of 250°C or lower. When the boiling point of a solvent is too high, the solvent evaporates more slowly.

The content of the solvent contained in the reflection layer-forming composition is preferably 1 to 15 mass% based on the total mass of the reflection layer-forming composition, more preferably 1 to 10 mass%, and still more preferably 3 to 10 mass%.

The reflection layer-forming composition may contain a reaction accelerator together with the organic silicon compound (in particular, polysilazane oligomer). The reaction accelerator may be either an acid or a base. Examples of the reaction accelerator include amines such as triethylamine, diethylamine, N,N-diethylethanolamine, N,N-dimethylethanolamine, triethanolamine, and triethylamine; acids such as hydrochloric acid, oxalic acid, fumaric acid, sulfonic acid, and acetic acid; and metal carboxylates containing nickel, iron, palladium, iridium, platinum, titanium, or aluminum. The reaction accelerator is particularly preferably a metal carboxylate. The amount of addition of the reaction accelerator is preferably 0.01 to 5 mol% based on the mass of a polysilazane oligomer.

FIG. 6 illustrates the outline of a sprayer for applying the reflection layer-forming composition. In applicator 200 illustrated in FIG. 6, reflection layer-forming composition 220 is supplied to coating liquid tank 210. Reflection layer-forming composition 220 inside this coating liquid tank 210 is pressurized and supplied to head 240 through connector tube 230. Reflection layer-forming composition 220 supplied to head 240 is discharged from nozzle 250, and is applied onto substrate 1. The discharging of reflection layer-forming composition 220 from nozzle 250 is carried out by means of wind pressure. Nozzle 250 may be configured to have an openable and closable port at the tip thereof, so that ON/OFF of the discharging operation is controlled by opening or closing the port.

At the time of applying the reflection layer-forming composition with the aforementioned sprayer, it is preferable to carry out operations and condition settings of the following (1) to (6).
(1) The tip of nozzle 250 is disposed immediately above substrate 1 to spray reflection layer-forming composition 220 from immediately above Substrate 1. In a case where substrate 1 has a cavity, reflection layer-forming composition 220 may be sprayed from diagonally above to allow reflection layer-forming composition after spraying 270 to be adhered to the cavity inner wall surface. Further, spraying of the reflection layer-forming composition 220 may be carried out while moving substrate 1 and nozzle 250 relatively.
(2) The spraying amount of reflection layer-forming composition 220 is controlled depending on the viscosity of the composition or the thickness of the reflection layer. As long as application is carried out under the same condition, the spraying amount is made constant, and the application amount per unit area is made constant. The variation of the spraying amount of reflection layer-forming composition 220 over time is set to be within 10%, and preferably within 1%. The spraying amount of reflection layer-forming composition 220 is adjusted according to the relative movement speed of nozzle 250 relative to substrate 1, the spraying pressure from nozzle 250, or the like. In general, in a case where the viscosity of reflection layer-forming composition 220 is higher, the relative movement speed of nozzle 250 is made slower, and the spraying pressure is set higher. The relative movement speed of the nozzle is typically about 30 to 200 mm/s; and the spraying pressure is typically about 0.01 to 0.2 MPa.
(3) Where necessary, the temperature of nozzle 250 is adjusted, and the viscosity of reflection layer-forming composition 220 at the time of spraying is adjusted.
(4) Where necessary, the temperature of substrate 1 is adjusted. A mechanism of adjusting the temperature of substrate 1 can be provided on a moving table (not illustrated) on which substrate 1 is placed. When the temperature of substrate 1 is set to 30 to 100°C, an organic solvent in reflection layer-forming composition 220 can be volatilized faster, enabling to suppress the dripping of reflection layer-forming composition 220 from substrate 1.
(5) The environmental atmosphere (temperature/humidity) of applicator 220 is made constant, to stabilize the spraying of reflection layer-forming composition 220. In particular, in a case where reflection layer-forming composition 200 contains a polysilazane oligomer, the polysilazane oligomer absorbs humidity, and thus there is a risk that reflection layer-forming composition 220 itself may be solidified. Therefore, it is preferable that the humidity at the time of spraying reflection layer-forming composition 220 is set to be lower.
(6) During the operations of spraying and application of reflection layer-forming composition 220, nozzle 250 may be cleaned. In this case, a cleaning tank in which a cleaning liquid is retained is provided in the vicinity of applicator 200. The tip of nozzle 250 is immersed in the cleaning tank during suspension of the spraying of reflection layer-forming composition 220, or during other operations, to prevent the tip of nozzle 250 from being dried. In addition, during suspension of the operations of spraying and application, there is a risk that reflection layer-forming composition 220 may be cured, and thus a spraying port of nozzle 250 may be clogged. Therefore, it is preferable that nozzle 250 is immersed in the cleaning tank, or that nozzle 250 is cleaned at the time of initiating the operations of spraying and application.

### (Method of Preparing Oligomer of Silane Compound)

The oligomer of a silane compound (polysiloxane oligomer) contained in the aforementioned reflection layer-forming composition can be prepared according to the following method. A monomer of a silane compound is hydrolyzed in the presence of an acid catalyst, water, and an organic solvent, followed by a condensation reaction. The mass mean molecular weight of oligomers of a silane compound is adjusted by reaction conditions (in particular, reaction time), or the like.

The mass mean molecular weight of oligomers of a silane compound contained in the reflection layer-forming composition is preferably 1,000 to 3,000, more preferably 1,200 to 2,700, and still more preferably 1,500 to 2,000. When the mass mean molecular weight of oligomers of a silane compound contained in the reflection layer-forming composition is less than 1,000, the viscosity of the reflection layer-forming composition is lowered, causing repelling of liquid, or the like to easily occur at the time of forming the reflection layer. On the other hand, when the mass mean molecular weight of oligomers of a silane compound contained in the reflection layer-forming composition exceeds 3,000, the viscosity of the reflection layer-forming composition becomes higher, and thus uniform film formation may be difficult. The mass mean molecular weight is a value measured by gel permeation chromatography (in terms of polystyrene).

Any acid catalyst for preparing an oligomer of a silane compound is sufficient as long as it functions as a catalyst at the time of hydrolysis of a silane compound, and may be either an organic acid or an inorganic acid. Examples of the inorganic acid include sulfuric acid, phosphoric acid, nitric acid, and hydrochloric acid, with phosphoric acid and nitric acid being particularly preferable. Further, examples of the organic acid include compounds having carboxylic acid residues, such as formic acid, oxalic acid, fumaric acid, maleic acid, glacial acetic acid, acetic anhydride, propionic acid, and n-butyric acid; and compounds having sulfur-containing acid residues, such as organic sulfonic acids, and esterified products of the organic sulfonic acids (organic sulfuric acid esters, organic sulfurous esters).

It is particularly preferable that the acid catalyst for preparing an oligomer of a silane compound is an organic sulfonic acid represented by the following general formula (VI):

R⁹-SO₃H (VI)

where the hydrocarbon group represented by R⁹ is a linear, branched or cyclic, saturated or unsaturated hydrocarbon group having 1 to 20 carbon atoms. Examples of a cyclic hydrocarbon group include an aromatic hydrocarbon group such as phenyl group, naphthyl group, or anthryl group, with phenyl group being preferable. Further, the hydrocarbon group represented by R⁹ in the general formul(VI) may have a substituent. Examples of the substituent include: linear, branched or cyclic, saturated or unsaturated hydrocarbon groups having 1 to 20 carbon atoms; halogen atoms such as fluorine atom; sulfonate group; carboxyl group; hydroxyl group; amino group; and cyano group.

The organic sulfonic acid represented by the aforementioned general formula (VI) is particularly preferably nonafluorobutane sulfonic acid, methanesulfonic acid, trifluoromethane sulfonic acid, or dodecylbenzenesulfonic acid.

The amount of the acid catalyst to be added at the time of preparing an oligomer of a silane compound is preferably 1 to 1,000 mass ppm based on the total amount of an oligomer preparation liquid, and more preferably 5 to 800 mass ppm.

Depending on the amount of water to be added at the time of preparing an oligomer of a silane compound, the film property of polysiloxane to be obtained varies. Therefore, it is preferable to adjust water addition ratio at the time of preparing an oligomer, depending on a target film property. The water addition ratio is a ratio (%) of the mole number of water molecules to be added, based on the mole number of an alkoxy group or an aryloxy group of a silane compound contained in an oligomer preparation liquid. The water addition ratio is preferably 50 to 200%, and more preferably 75 to 180%. By setting the water addition ratio to 50% or higher, the film property of the reflection layer is stabilized. Further, by setting the water addition ratio to 200% or lower, the storage ability of the reflection layer-forming composition becomes better.

Examples of a solvent to be added at the time of preparing an oligomer of a silane compound include: monovalent alcohols such as methanol, ethanol, propanol, and n-butanol; alkylcarboxylic acid esters such as methyl-3-methoxy propionate, and ethyl-3-ethoxy propionate; polyvalent alcohols such as ethylene glycol, diethylene glycol, propylene glycol, glycerin, trimethylolpropane, and hexanetriol; polyvalent alcohol monoethers such as ethyleneglycol monomethylether, ethyleneglycol monoethylether, ethyleneglycol monopropylether, ethyleneglycol monobutylether, diethyleneglycol monomethylether, diethyleneglycol monoethylether, diethyleneglycol monopropylether, diethyleneglycol monobutylether, propyleneglycol monomethylether, propyleneglycol monoethylether, propyleneglycol monopropylether, and propyleneglycol monobutylether, or monoacetates thereof; esters such as methyl acetate, ethyl acetate, and butyl acetate; ketones such as acetone, methyl ethyl ketone, and methyl isoamyl ketone; and polyvalent alcohol ethers obtained by alkyl-etherifying all of the hydroxyl groups of polyvalent alcohols, such as ethylene glycol dimethyl ether, ethylene glycol diethyl ether, ethylene glycol dipropyl ether, ethylene glycol dibutyl ether, propylene glycol dimethyl ether, propylene glycol diethyl ether, diethylene glycol dimethyl ether, diethylene glycol diethyl ether, and diethylene glycol methylethyl ether. One type of these solvents may be added alone, or two or more types thereof may be added.

### · Step 3)

Wavelength conversion layer 11 is formed so as to cover reflection layer 21 and LED element 2. Wavelength conversion layer 11 can be obtained by preparing a wavelength conversion layer-forming composition containing a transparent resin or a precursor thereof, and phosphor particles, and then applying this composition so as to cover LED element 2 and reflection layer 21, followed by curing.

The wavelength conversion layer-forming composition contains a transparent resin or a precursor thereof, and phosphor particles. Where necessary, a solvent or various additives may be contained. The solvent is not particularly limited as long as it is capable of dissolving the aforementioned transparent resin or a precursor thereof, and examples thereof can include hydrocarbons such as toluene, and xylene; ketones such as acetone, and methyl ethyl ketone; ethers such as diethyl ether, tetrahydrofuran; and esters such as propylene glycol monomethyl ether acetate, and ethyl acetate.

Mixing of the wavelength conversion layer-forming composition can be carried out using, for example, a stirrer mill, a blade kneader, or a thin-film spin dispersing machine. By adjusting the conditions for stirring, settling of phosphor particles in the wavelength conversion layer-forming composition can be suppressed.

The method of applying the wavelength conversion layer-forming composition is not particularly limited. For example, the wavelength conversion layer-forming composition can be applied with a general applicator such as a dispenser. Further, the curing method and the curing condition of the wavelength conversion layer-forming composition are appropriately selected depending on the types of a transparent resin. One example of the curing method includes heat curing.

### (2) Second Mode

In the case of forming reflection layer 21 before mounting LED element 2, a method of manufacturing an LED device includes the following three steps:
1) applying a reflection layer-forming composition to a desired area of a substrate, followed by curing;
2) mounting an LED element on the substrate; and
3) forming a wavelength conversion layer so as to cover a reflection layer and the LED element.

In the present mode, LED element 2 is mounted after reflection layer 21 is formed on substrate 1. Therefore, a reflection layer-forming composition is applied such that the reflection layer-forming composition is not adhered to a connection area between metal part (metal electrode part) 3 and LED element 2. At that time, the reflection layer-forming composition may be applied such that the reflection layer-forming composition is not adhered to the entire area of metal part 3,3'.

### · Step 1)

The methods of forming a reflection layer only on a desired area of substrate 1 include the following three methods:
(i) applying a reflection layer-forming composition onto substrate 1 while protecting a partial area or the entire area of metal part 3,3', followed by curing;
(ii) applying a reflection layer-forming composition only to a desired area without protecting metal part 3,3', followed by curing; and
(iii) adhering a reflection layer-forming composition only to a desired area using a metal mold, followed by curing.

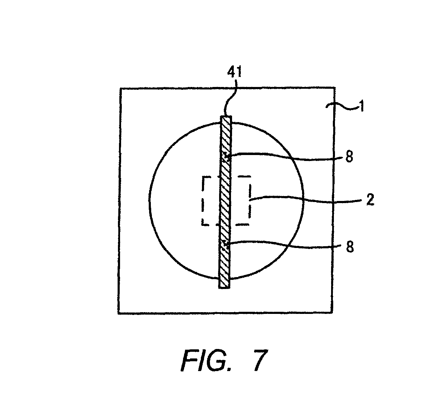

In the method of (i), an area where a reflection layer is not formed, i.e., a partial area of metal part 3,3', or the entire area of metal part 3,3' is protected. The method of protection is not particularly limited; for example, as illustrated in FIG. 7, plate-like mask 41 may be disposed in an area to be protected (in FIG. 7, above connection area 8 between metal part (metal electrode part) 3 and LED element 2). Further, a cap that protects a part or all of metal part 3,3' may be disposed on substrate 1. Furthermore, a resist mask may be formed on metal part 3,3'.

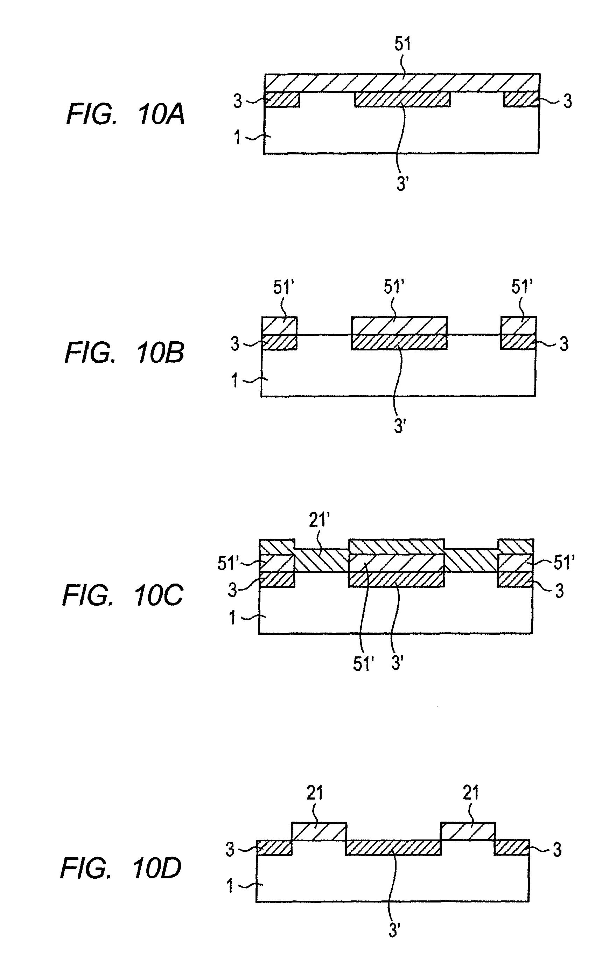

The method of forming a resist mask is illustrated in FIGS. 10A and 10B. First, resist material 51 is applied onto substrate 1 having metal part 3,3' (FIG. 10A). Then, a portion of resist material 51 where a reflection layer is formed is removed to obtain resist mask 51' that protects an area where a reflection layer is not formed (FIG. 10B).

The method of applying resist material 51 is not particularly limited, and can be, for example, spray application method or dispenser application method. Further, when substrate 1 has a plate-like shape, the application of resist material 51 may be carried out by screen printing. Further, resist material 51 is not particularly limited, and can be, for example, a general positive photosensitive material such as a naphthoquinone diazide compound, a negative photosensitive material such as a bis-azide compound, or the like. On the other hand, the curing method of a resist is appropriately selected depending on the types of a resist material, and can be irradiation of light of a specific wavelength, heat treatment, or the like. The removing method of a resist material can be a method of dissolving/removing, or the like, the resist material with a resist developing solution, or the like.

The method of forming resist mask 51 is not limited to the aforementioned method. Resist material 51 may be adhered only to a desired area, for example, by dispenser application method or inkjet method to form resist mask 51'. Further, a plate-like mask, a cap, or the like may be disposed on an area where a resist mask is not formed, before resist material 51 is applied, to form resist mask 51'.

Further, instead of a resist material, a water-soluble resin such as polyvinyl alcohol may be used to form a mask. In this case, the water-soluble resin is applied to a portion where a reflection layer is not formed, followed by drying. The method of applying the water-soluble resin is not particularly limited, and can be, for example, dispenser application method, or ink jet method. Further, when substrate 1 has a plate-like shape, screen printing method can also be adopted.

After protecting a desired area with resist mask 51', or the like, as illustrated in FIG. 10C, reflection layer-forming composition 21' is applied onto substrate 1, for example. The means of applying reflection layer-forming composition 21' is not particularly limited, and can be, for example, dispenser application method, or spray application method. When the application means is spray application, it is possible to form reflection layer 21 with smaller thickness. Further, in a case where substrate 1 has a cavity, it is easier to apply a reflection layer-forming composition to inner wall surface 6 of the cavity. The composition of a reflection layer-forming composition can be the same as that of the first mode.

After application of reflection layer-forming composition 21' to substrate 1, the reflection layer-forming composition is dried and cured. The method of drying/curing of the reflection layer-forming composition can be the same as that for the first mode. After curing of the reflection layer-forming composition, a mask or a cap is removed, thereby forming reflection layer 21 only on a desired area (FIG. 10D). The removing method of a mask or a cap is appropriately selected depending on the types thereof. For example, as for plate-like mask 41 and a cap, it is sufficient if they are removed. On the other hand, as for resist mask 51', it is sufficient if it is removed by etching. Examples of the etching method include general dry etching method, and wet etching method. Further, for a water-soluble resin such as polyvinyl alcohol, there can be adopted, for example, a method of dissolving and removing the water-soluble resin with water.

In the method of (ii), a reflection layer-forming composition is applied without protecting an area where reflection layer 21 is not formed. The means of applying the reflection layer-forming composition can be dispenser application method, or inkjet application method. When substrate 1 has a plate-like shape, the application of a reflection layer-forming composition may be carried out by screen printing method. After application of the reflection layer-forming composition, the reflection layer-forming composition is dried and cured in the same manner as in the method of (i).

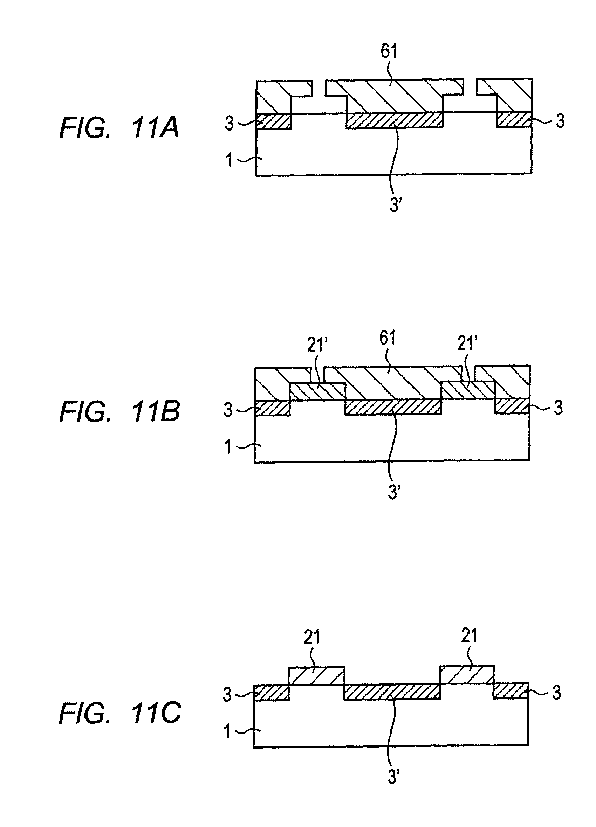

In the method of (iii), a reflection layer-forming composition is adhered only to a desired area using a metal mold, followed by curing. Specifically, metal mold 61 havingthe shape of a reflection layer is provided, and disposed on substrate 1 (FIG. 11A). Reflection layer-forming composition 21' is then injected into metal mold 61, followed by drying and curing of the reflection layer-forming composition (FIG. 11B), and subsequently metal mold 61 is taken out (FIG. 11C). It is noted that, after metal mold 61 is taken out, an unnecessary portion of reflection layer 21 may be shaved where necessary, to align the shape of reflection layer 21. The drying/curing temperature and the drying/curing time of the reflection layer-forming composition can be the same as those in the method of (i).

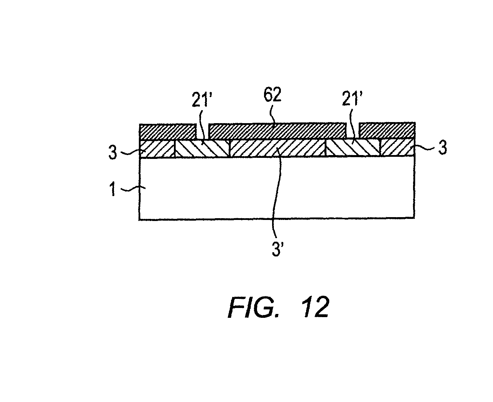

Further, in a case where metal part 3,3' of substrate 1 is protruded from the surface of substrate 1, as illustrated in FIG. 12, plate-like metal mold 62 may be used. Specifically, plate-like metal mold 62 is provided and disposed on metal part 3,3'. Reflection layer-forming composition 21' is then injected into between metal mold 61 and the substrate, to dry and cure reflection layer-forming composition 21'. Then, metal mold 61 is taken out to obtain desired reflection layer 21.

Metal molds 61 and 62 are not particularly limited as long as they have solvent resistance and heat resistance, and may be those which are composed of any material such as resin, metal, ceramic, or rubber. It is preferable that a releasing agent is applied to metal mold 61. The releasing agent can be a silicone-based releasing agent, a fluorine compound releasing agent, or the like.

### · Step 2)

LED element 2 is disposed on reflection layer 21 formed in Step 1). At that time, metal part (metal electrode part) 3 in an area where reflection layer 2 is not formed and LED element 2 are connected to be fixed to each other. LED element 2 and metal part (metal electrode) 3 may be connected to each other through interconnection 4 as illustrated in FIG. 1, or may be connected to each other through bump electrode 5 as illustrated in FIG. 5.

### · Step 3)

Wavelength conversion layer 11 is formed so as to cover reflection layer 21 and LED element 2. Wavelength conversion layer 11 can be obtained by preparing a wavelength conversion layer-forming composition containing a transparent resin or a precursor thereof and phosphor particles, and applying this composition so as to cover LED chip 2 and reflection layer 21 followed by curing. The method for forming wavelength conversion layer 11 can be the same as that of step 3) of the first mode.

### Examples

The present invention will now be described in more detail with reference to Examples, which however shall not be construed as limiting the scope of the present invention.

### (1) Provision of Package

A substrate having a cavity as illustrated in FIG. 1 was provided. The substrate was composed of polyphthalamide (PPA) resin. The substrate that is a cuboid of 3.2 × 2.8 × 1.8 mm was designed such that a frustum-shaped cavity was formed which has opening diameter: 2.4 mm, wall angle: 45°; and depth: 0.85 mm. An LED element was mounted on this substrate. The outer dimension of the LED element was set to 305µm × 330µm × 100 µm. Further, the peak wavelength of the LED element was set to 475 nm.

### (2) Provision of Wavelength Conversion Layer-Forming Composition

A silicone resin (KER 2600 available from Shin-Etsu Chemical Co., Ltd.) and a yellow phosphor (available from Nemoto & Co., Ltd.; YAG 450C205 (volume mean particle diameter, particle diameter D50: 20.5µm)) were mixed to prepare a wavelength conversion layer-forming composition. The concentration of the yellow phosphor in the wavelength conversion layer-forming composition was set to 5 mass%.

### (3) Production of LED Device

### [Comparative Example 1]

A wavelength conversion layer-forming composition was potted onto the aforementioned package using a dispenser, and allowed to stand at 150°C for 2 hours to form a wavelength conversion layer.

### [Comparative Example 2]

1 g of one-pack type liquid cation curable epoxy resin (available from FINE POLYMERS CORPORATION; Epi Fine), 1 g of titanium oxide (available from Ishihara Sangyo Kaisha, Ltd.), 0.25 g of propylene glycol monomethyl ether acetate, and 0.05 g of silicon oxide (available from Nippon Aerosil Co., Ltd.; AEROSIL 380) were mixed to prepare a reflection layer-forming composition.

The aforementioned package was placed on a moving table of a sprayer. The reflection layer-forming composition was spray-applied to a substrate while protecting the emission surface of an LED element inside the package with mask 41 illustrated in FIG. 5. At that time, the discharge pressure of the reflection layer-forming composition was set to 0.15 MPa. In addition, the nozzle was moved such that the nozzle reciprocated from one end to the other end of the substrate once. The movement speed of the nozzle was set to 70 mm/s.

The package to which the reflection layer-forming composition was applied was allowed to stand at 40°C for 1 hour, 100°C for 1 hour, and further at 150°C for 1 hour to cure an epoxy resin. Then, a wavelength conversion layer-forming composition was potted into the package using a dispenser to form a wavelength conversion layer in the package in the same manner as in Comparative Example 1.

### [Example 1]

5.0 g of titanium oxide (available from Fuji Titanium Industry Co. Ltd.; TA-100, particle diameter 600 nm) was mixed into 7.0 g of polysilazane oligomer (polysilazane (AZ Electronic Materials Co. Ltd., NN120, 20 mass%, dibutylether 80 mass%)) to prepare a reflection layer-forming composition. The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 100 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### [Example 2]

3.25 g of tetramethoxysilane, 4.00 g of methanol, and 4.00 g of acetone were mixed and stirred. 5.46 g of water and 4.7 µL of an aqueous nitric acid solution having a concentration of 60 mass% were added to the liquid mixture. The liquid mixture was further stirred for 3 hours to obtain a polysiloxane oligomer solution. Subsequently, 12.0 g of barium sulfate (Sakai Chemical Industry Co., Ltd.; BF-10, particle diameter 600 nm) and 1 g of 1,3-butanediol were mixed into the polysiloxane oligomer solution to prepare a reflection layer-forming composition.

The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 100 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### [Example 3]

3.25 g of tetramethoxysilane, 4.00 g of methanol, and 4.00 g of acetone were mixed and stirred. 5.46 g of water and 4.7 µL of an aqueous nitric acid solution having a concentration of 60 mass% were added to the liquid mixture. The liquid mixture was further stirred for 3 hours to obtain a polysiloxane oligomer solution. Subsequently, 12.0 g of titanium oxide (Fuji Titanium Industry Co. Ltd.; TA-100, particle diameter 600 nm) and 1 g of 1,3-butanediol were mixed into the polysiloxane oligomer solution to prepare a reflection layer-forming composition.

The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 160 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### [Example 4]

In the same manner as in Example 3, a reflection layer-forming composition was prepared. The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 100 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### [Example 5]

In the same manner as in Example 3, a reflection layer-forming composition was prepared. The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 70 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### [Example 6]

0.89 g of methyltrimethoxysilane, 2.30 g of tetramethoxysilane, 4.00 g of methanol, and 4.00 g of acetone were mixed and stirred. 5.46 g of water and 4.7 µL of an aqueous nitric acid solution having a concentration of 60 mass% were added to the liquid mixture. The liquid mixture was further stirred for 3 hours to obtain a polysiloxane oligomer solution containing polysiloxane oligomers at a ratio of trifunctional components: tetrafunctional components (polymerization ratio) = 3:7. Subsequently, 12.0 g of titanium oxide (Fuji Titanium Industry Co. Ltd.; TA-100, particle diameter 600 nm) and 1 g of 1,3-butanediol were mixed into the polysiloxane oligomer solution to prepare a reflection layer-forming composition.

The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 100 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### [Example 7]

2.10 g of methyltrimethoxysilane, 0.98 g of tetramethoxysilane, 4.00 g of methanol, and 4.00 g of acetone were mixed and stirred. 5.46 g of water and 4.7 µL of an aqueous nitric acid solution having a concentration of 60 mass% were added to the liquid mixture. The liquid mixture was further stirred for 3 hours to obtain a polysiloxane oligomer solution containing polysiloxane oligomers at a ratio of trifunctional components: tetrafunctional components (polymerization ratio) = 7:3. Subsequently, 12.0 g of titanium oxide (Fuji Titanium Industry Co. Ltd.; TA-100, particle diameter 600 nm) and 1 g of 1,3-butanediol were mixed into the polysiloxane oligomer solution to prepare a reflection layer-forming composition.

The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 100 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### [Example 8]

2.40 g of methyltrimethoxysilane, 0.65 g of tetramethoxysilane, 4.00 g of methanol, and 4.00 g of acetone were mixed and stirred. 5.46 g of water and 4.7 µL of an aqueous nitric acid solution having a concentration of 60 mass% were added to the liquid mixture. The liquid mixture was further stirred for 3 hours to obtain a polysiloxane oligomer solution containing polysiloxane oligomers at a ratio of trifunctional components: tetrafunctional components (polymerization ratio) = 8:2. Subsequently, 12.0 g of titanium oxide (Fuji Titanium Industry Co. Ltd.; TA-100, particle diameter 600 nm) and 1 g of 1,3-butanediol were mixed into the polysiloxane oligomer solution to prepare a reflection layer-forming composition.

The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 100 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### [Example 9]

1.20 g of methyltrimethoxysilane, 1.95 g of tetramethoxysilane, 4.00 g of methanol, and 4.00 g of acetone were mixed and stirred. 5.46 g of water and 4.7 µL of an aqueous nitric acid solution having a concentration of 60 mass% were added to the liquid mixture. The liquid mixture was further stirred for 3 hours to obtain a polysiloxane oligomer solution containing polysiloxane oligomers at a ratio of trifunctional components: tetrafunctional components (polymerization ratio) = 4:6.

Subsequently, 2.0 g of a dispersion liquid of zirconium oxide (ZrO₂) having a mean primary particle diameter of 5 nm (a 30 mass% methanol solution available from Sakai Chemical Industry Co., Ltd.), 12.0 g of titanium oxide (Fuji Titanium Industry Co. Ltd.; TA-100, particle diameter 600 nm), and 1 g of 1,3-butanediol were mixed into the polysiloxane oligomer solution to prepare a reflection layer-forming composition.

The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 100 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### [Example 10]

2.40 g of methyltrimethoxysilane, 3.90 g of tetramethoxysilane, 4.00 g of methanol, and 4.00 g of acetone were mixed and stirred. 5.46 g of water and 4.7 µL of an aqueous nitric acid solution having a concentration of 60 mass% were added to the liquid mixture. The liquid mixture was further stirred for 3 hours to obtain a polysiloxane oligomer solution containing polysiloxane oligomers at a ratio of trifunctional components: tetrafunctional components (polymerization ratio) = 4:6.

Subsequently, acetyl acetone (available from Kanto Chemical Co., Inc.) as a stabilizer was added to the polysiloxane oligomer solution in an amount of 10 mass% based on the total amount of the polysiloxane oligomer solution. Further, a Zr chelate solution (ZC-580 (available from Matsumoto Fine Chemical Co., Ltd.)), 3.0 g of a dispersion liquid of zirconium oxide (ZrO₂) having a mean primary particle diameter of 5 nm (a 30 mass% methanol solution available from Sakai Chemical Industry Co., Ltd.), 12.0 g of titanium oxide (Fuji Titanium Industry Co. Ltd.; TA-100, particle diameter 600 nm), and 1 g of 1,3-butanediol were mixed to prepare a reflection layer-forming composition. The amount of addition of the Zr chelate solution was set such that the amount of Zr chelate was 10 mass% based on the total of the solid contents of the polysiloxane oligomer solution, the Zr chelate solution, and the zirconium oxide dispersion liquid.

The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 100 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### [Example 11]

2.40 g of methyltrimethoxysilane, 3.90 g of tetramethoxysilane, 4.00 g of methanol, and 4.00 g of acetone were mixed and stirred. 5.46 g of water and 4.7 µL of an aqueous nitric acid solution having a concentration of 60 mass% were added to the liquid mixture. The liquid mixture was further stirred for 3 hours to obtain a polysiloxane oligomer solution containing polysiloxane oligomers at a ratio of trifunctional components: tetrafunctional components (polymerization ratio) = 4:6. Subsequently, acetyl acetone (available from Kanto Chemical Co., Inc.) as a stabilizer was added to the polysiloxane oligomer solution in an amount of 10 mass% based on the total amount of the polysiloxane solution. Further, Al alkoxide (ALR15GB (available from Kojundo Chemical Lab. Co., Ltd.)), 3.0 g of a dispersion liquid of zirconium oxide (ZrO₂) having a mean primary particle diameter of 5 nm (a 30 mass% methanol solution available from Sakai Chemical Industry Co., Ltd.), 12.0 g of titanium oxide (Fuji Titanium Industry Co. Ltd.; TA-100, particle diameter 600 nm), and 1 g of 1,3-butanediol were mixed to prepare a liquid mixture. The amount of addition of Al alkoxide was set such that the amount of Al alkoxide was 10 mass% based on the total of the solid contents of the polysiloxane oligomer solution, the Al alkoxide, and the zirconium oxide dispersion liquid.

The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 100 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### [Example 12]

A reflection layer-forming composition was prepared in the same manner as in Example 3.

The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 180 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### [Example 13]

A reflection layer-forming composition was prepared in the same manner as in Example 3. The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 50 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### (4) Evaluation of LED Device

For each of the LED devices produced in Comparative Examples 1 and 2 and Examples 1 to 13, the thickness of the reflection layer, total luminous flux value, total luminous flux value after durability test, deterioration rate, and adhesion were evaluated by the following methods. The results are shown in Table 1.

### (4-1) Measurement of Film Thickness

During production of each of the LED devices, the film thickness of the reflection layer was measured using Laser Hologage (Mitutoyo Corporation).

### (4-2) Measurement of Total Luminous Flux Value

The total luminous flux value of each of the LED devices was measured using spectroradiometer (CS-1000A available from Konica Minolta Sensing, Inc.). The values were relatively evaluated, with the measurement result of an LED device in the case of not forming a reflection layer (Comparative Example 1) being set as 100.

### (4-3) Measurement of Total Luminous Flux Value After Durability Test

For LED devices produced in Examples and Comparative Examples, each of the LED devices was allowed to emit light at a current value of 20 mA in a constant temperature bath at 100°C. 1000 hours after the light emission, the total luminous flux value was measured for each of the LED devices. The total luminous flux values before and after durability test were compared with each other to calculate deterioration rate. The deterioration rate was determined by (1 - (relative value of total luminous flux value after durability test / relative value of total luminous flux value before durability test)) × 100. In a case where the deterioration rate was 15% or more, it was judged that deterioration of the LED device occurred. Further, in a case where the deterioration rate was 10% or more and less than 15%, it was judged that there was almost no deterioration of the LED device with no actual damage, but that a slight crack, or the like occurred in the reflection layer. Furthermore, when the deterioration rate was less than 10%, it was judged that there was no deterioration of the LED device, and that no crack occurred in the reflection layer, either.

### (4-4) Measurement of Adhesion

For the LED devices produced in Examples and Comparative Examples, heat shock test was carried out using a heat shock tester (TSA-42EL available from ESPEC Corp.). In this test, a step of storing an LED device at -40°C for 30 minutes and then storing it at 100°C for 30 minutes was set as one cycle, and 3,000 cycles of this step were carried out. A sample after the test was observed with an optical microscope (available from Olympus Corporation; BX50), and it was confirmed whether or not peeling-off occurred at each of the interface between the substrate and the reflection layer and the interface between the reflection layer and the wavelength conversion layer.
C: There is no actual damage, but peeling-off occurs partially.
B: There occurs slight peeling-off.
A: There is no peeling-off.

**[Table 1]**

| | Reflection Layer | | | | | Evaluation | | | | |
|---|---|---|---|---|---|---|---|---|---|---|
| | Light Diffusion Particles | Binder | Polysiloxane Trifunctional: Tetrafunctional (Polymerization Ratio) | Metal Oxide Microparticles | Metal Alkoxide /Metal Chelate | Film Thickness (µm) | Total Luminous Flux Value (Relative Value) | Total Luminous Flux Value After Luminescence Test (Relative Value) | Deterioration Rate (%) | Adhesion |
| Comp. Ex.1 | None | - | - | - | - | - | 100 | - | - | - |
| Comp. Ex.2 | Titanium Oxide | Epoxy Resin | - | - | - | 15 | 130 | 85 ^{*1}95 | 35 ^{*2}27 | - |
| Ex.1 | Titanium Oxide | Polysilazane | - | - | - | 15 | 140 | 124 | 11 | C |
| Ex.2 | Barium Suffate | Polysiloxane | 0:10 | - | - | 15 | 139 | 123 | 12 | C |
| Ex.3 | Titanium Oxide | Polysiloxane | 0:10 | - | - | 5 | 128 | 112 | 13 | C |
| Ex.4 | Titanium Oxide | Polysiloxane | 0:10 | - | - | 15 | 142 | 125 | 12 | C |
| Ex.5 | Titanium Oxide | Polysiloxane | 0:10 | - | - | 30 | 145 | 124 | 14 | C |
| Ex.6 | Titanium Oxide | Polysiloxane | 3:7 | - | - | 15 | 142 | 135 | 5 | C |
| Ex.7 | Titanium Oxide | Polysiloxane | 7:3 | - | - | 15 | 144 | 136 | 6 | C |
| Ex.8 | Titanium Oxide | Polysiloxane | 8:2 | - | - | 15 | 142 | 128 | 10 | C |
| Ex.9 | Titanium Oxide | Polysiloxane | 4:6 | Zirconium Oxide | - | 15 | 138 | 132 | 4 | B |
| Ex.10 | Titanium Oxide | Polysiloxane | 4:6 | Zirconium Oxide | Zirconium Chelate | 15 | 145 | 132 | 9 | A |
| Ex.11 | Titanium Oxide | Polysiloxane | 4:6 | Zirconium Oxide | Aluminium Alkoxide* | 15 | 144 | 128 | 11 | A |
| Ex.12 | Titanium Oxide | Polysiloxane | 0:10 | - | - | 3 | 102 | - ^{*1}93 | - ^{*2}9 | - |
| Ex.13 | Titanium Oxide | Polysiloxane | 0:10 | - | - | 35 | 150 | ^{*1}137 | ^{*2}9 | - |

| | | | | | | | | | | |
|---|---|---|---|---|---|---|---|---|---|---|
| ^{*1} Total Luminous Flux Value (Relative Value) after 500-hour light emission in constant temperature bath at 100°C ^{*2} Deterioration Rate after 500-hour light emission in constant temperature bath at 100°C | | | | | | | | | | |

As shown in Table 1, compared to the case of not forming a reflection layer (Comparative Example 1), in the case of forming a reflection layer in which a binder was resin (Comparative Example 2), the total luminous flux value was good immediately after the production of an LED device, while the total luminous flux value was extremely decreased after durability test. It is deduced that epoxy resin as a binder was deteriorated due to the durability test.

On the other hand, in a case where the binder of the reflection layer was polysilazane (Example 1), and in a case where the binder of the reflection layer was polysiloxane (Examples 2 to 11), not only the total luminous flux value immediately after the production of an LED device was higher, but also the total luminous flux value after the durability test was higher (deterioration rate was lower). At that time, either when light diffusion particles were composed of titanium oxide (Example 4), or when composed of barium sulfate (Example 2), good results were obtained as well.

On the other hand, even if the binder of the reflection layer was polysiloxane, when the film thickness of the reflection layer was less than 5 µm (Example 12), the total luminous flux value was somewhat raised, but there was less effect of improving out-coupling efficiency compared to Examples 1 to 11. However, in the LED device of Example 12, even if durability test (500 hours) was carried out, the total luminous flux value was not easily lowered. It is deduced that, since the binder of the reflection layer was polysiloxane, the reflection layer was not easily deteriorated.

Further, even if the binder of the reflection layer was polysiloxane, the film thickness of the reflection layer exceeded 30 µm (Example 13), there occurred a crack in the reflection layer during 1,000-hour durability test. However, in the 500-hour durability test, cracks did not occur in the reflection layer, and the total luminous flux value was not easily lowered.

Further, in a case where polysiloxane as the binder of the reflection layer was a polymer of a trifunctional silane compound and a tetrafunctional silane compound (Examples 6 to 11), the deterioration rate was small compared to the case where the polysiloxane was a polymer made only of a tetrafunctional silane compound (Examples 2 to 5). In a case where the ratio of a trifunctional silane compound and a tetrafunctional silane compound was 3:7 to 7:3 (Examples 6, 7 and 9 to 11), the deterioration rate was particularly lower.

Further, in a case where zirconium oxide microparticles added are contained in the reflection layer (Examples 9 to 11), adhesion at an interface between the respective layers was better. It is deduced that metal oxide microparticles being included therein allows an anchor effect to occur at the interface between the reflection layer and the wavelength conversion layer. Furthermore, in a case where a metal alkoxide or a metal chelate was contained (Examples 10 and 11), in particular, the adhesion between the respective layers was better. It is deduced that, formation of metalloxane bonding by metals contained in the metal alkoxide or the metal chelate with a hydroxyl group on the surface of the substrate made the adhesion better.

### (5) Production of LED Device

### [Example 14]

0.3 g of dimethyldimethoxysilane, 3.06 g of methyltrimethoxysilane, 4.00 g of methanol, and 4.00 g of acetone were mixed and stirred. 5.46 g of water and 4.7 µL of an aqueous nitric acid solution having a concentration of 60 mass% were added to the liquid mixture. The liquid mixture was further stirred for 3 hours to obtain a polysiloxane oligomer solution having a polymerization ratio of bifunctional components to trifunctional components being 1:9. Subsequently, 12.0 g of titanium oxide (Fuji Titanium Industry Co. Ltd.; TA-100, particle diameter 600 nm) and 1 g of 1,3-butanediol were mixed into the polysiloxane oligomer solution to prepare a reflection layer-forming composition.

The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 160 mm/s. Then, heating was carried out at 150 °C for 1 hour to form a reflection layer. A wavelength conversion layer-forming composition was potted into the package in which the reflection layer was formed using a dispenser to form a wavelength conversion layer in the same manner as in Comparative Example 1.

### [Example 15]

Except that the movement speed of the nozzle during application was set to 65 mm/s, an LED device was produced in the same manner as in Example 14.

### [Example 16]

Except that the movement speed of the nozzle during application was set to 40 mm/s, an LED device was produced in the same manner as in Example 14.

### [Example 17]

Except that the movement speed of the nozzle during application was set to 30 mm/s, an LED device was produced in the same manner as in Example 14.

### [Example 18]

Except that the amount of dimethyldimethoxysilane and the amount of methyltrimethoxysilane were changed, respectively, to 0.9 g and 2.37 g at the time of preparing a reflection layer-forming composition, an LED device was produced in the same manner as in Example 15.

### [Example 19]

Except that the amount of dimethyldimethoxysilane and the amount of methyltrimethoxysilane were changed, respectively, to 1.7 g and 2.04 g at the time of preparing a reflection layer-forming composition, an LED device was produced in the same manner as in Example 15.

### [Example 20]

0.28 g of dimethyldimethoxysilane, 2.2 g of methyltrimethoxysilane, 0.71 g of tetramethoxysilane, 4.00 g of methanol, and 4.00 g of acetone were mixed and stirred. 5.46 g of water and 4.7 µL of an aqueous nitric acid solution having a concentration of 60 mass% were added to the liquid mixture. The liquid mixture was further stirred for 3 hours to obtain a polysiloxane oligomer solution. Subsequently, 12.0 g of titanium oxide (Fuji Titanium Industry Co. Ltd.; TA-100, particle diameter 600 nm) and 1 g of 1,3-butanediol were mixed into the polysiloxane oligomer solution to prepare a reflection layer-forming composition.

Except that the reflection layer-forming composition was applied to form a reflection layer, an LED device was produced in the same manner as in Example 15.

### [Example 21]

0.3 g of dimethyldimethoxysilane, 3.06 g of methyltrimethoxysilane, 4.00 g of methanol, and 4.00 g of acetone were mixed and stirred. 5.46 g of water and 4.7 µL of an aqueous nitric acid solution having a concentration of 60 mass% were added to the liquid mixture. The liquid mixture was further stirred for 3 hours to obtain a polysiloxane oligomer solution containing polysiloxane oligomers at a ratio of bifunctional components: trifunctional components (polymerization ratio) = 1:9. Subsequently, 2.0 g of a dispersion liquid of zirconium oxide (ZrO₂) having a mean primary particle diameter of 5 nm (a 30 mass% methanol solution available from Sakai Chemical Industry Co., Ltd.), 12.0 g of titanium oxide (Fuji Titanium Industry Co. Ltd.; TA-100, particle diameter 600 nm), and 1 g of 1,3-butanediol were mixed into the polysiloxane oligomer solution to prepare a reflection layer-forming composition.

The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 65 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### [Example 22]

0.3 g of dimethyldimethoxysilane, 3.06 g of methyltrimethoxysilane, 4.00 g of methanol, and 4.00 g of acetone were mixed and stirred. 5.46 g of water and 4.7 µL of an aqueous nitric acid solution having a concentration of 60 mass% were added to the liquid mixture. The liquid mixture was further stirred for 3 hours to obtain a polysiloxane oligomer solution containing polysiloxane oligomers at a ratio of bifunctional components: trifunctional components (polymerization ratio) = 1:9. Subsequently, acetyl acetone (available from Kanto Chemical Co., Inc.) as a stabilizer was added to the polysiloxane oligomer solution in an amount of 10 mass% based on the total amount of the polysiloxane oligomer solution. Further, a Zr chelate solution (ZC-580 (available from Matsumoto Fine Chemical Co., Ltd.)), 3.0 g of a dispersion liquid of zirconium oxide (ZrO₂) having a mean primary particle diameter of 5 nm (a 30 mass% methanol solution available from Sakai Chemical Industry Co., Ltd.), 12.0 g of titanium oxide (Fuji Titanium Industry Co. Ltd.; TA-100, particle diameter 600 nm), and 1 g of 1,3-butanediol were mixed to prepare a reflection layer-forming composition. The amount of addition of the Zr chelate solution was set such that the amount of Zr chelate was 10 mass% based on the total of the solid contents of the polysiloxane oligomer solution, the Zr chelate solution, and the zirconium oxide dispersion liquid.

The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 65 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### [Example 23]

0.28 g of dimethyldimethoxysilane, 2.22 g of methyltrimethoxysilane, 0.71 g of tetramethoxysilane, 4.00 g of methanol, and 4.00 g of acetone were mixed and stirred. 5.46 g of water and 4.7 µL of an aqueous nitric acid solution having a concentration of 60 mass% were added to the liquid mixture. The liquid mixture was further stirred for 3 hours to obtain a polysiloxane oligomer solution containing polysiloxane oligomers at a ratio of bifunctional components: trifunctional components (polymerization ratio) = 1:9. Subsequently, 2.0 g of a dispersion liquid of zirconium oxide (ZrO₂) having a mean primary particle diameter of 5 nm (a 30 mass% methanol solution available from Sakai Chemical Industry Co., Ltd.), 12.0 g of titanium oxide (Fuji Titanium Industry Co. Ltd.; TA-100, particle diameter 600 nm), and 1 g of 1,3-butanediol were mixed into the polysiloxane oligomer solution to prepare a reflection layer-forming composition.

The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 65 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### [Example 24]

0.28 g of dimethyldimethoxysilane, 2.22 g of methyltrimethoxysilane, 0.71 g of tetramethoxysilane, 4.00 g of methanol, and 4.00 g of acetone were mixed and stirred. 5.46 g of water and 4.7 µL of an aqueous nitric acid solution having a concentration of 60 mass% were added to the liquid mixture. The liquid mixture was further stirred for 3 hours to obtain a polysiloxane oligomer solution containing polysiloxane oligomers at a ratio of bifunctional components: trifunctional components (polymerization ratio) = 1:9. Subsequently, acetyl acetone (available from Kanto Chemical Co., Inc.) as a stabilizer was added to the polysiloxane oligomer solution in an amount of 10 mass% based on the total amount of the polysiloxane oligomer solution. Further, a Zr chelate solution (ZC-580 (available from Matsumoto Fine Chemical Co., Ltd.)), 3.0 g of a dispersion liquid of zirconium oxide (ZrO₂) having a mean primary particle diameter of 5 nm (a 30 mass% methanol solution available from Sakai Chemical Industry Co., Ltd.), 12.0 g of titanium oxide (Fuji Titanium Industry Co. Ltd.; TA-100, particle diameter 600 nm), and 1 g of 1,3-butanediol were mixed to prepare a reflection layer-forming composition. The amount of addition of the Zr chelate solution was set such that the amount of Zr chelate was 10 mass% based on the total of the solid contents of the polysiloxane oligomer solution, the Zr chelate solution, and the zirconium oxide dispersion liquid.

The reflection layer-forming composition was applied onto a substrate in the same manner as in Comparative Example 2. At that time, the discharge pressure of the reflection layer-forming composition was set to 0.1 MPa. In addition, the movement speed of the nozzle was set to 65 mm/s. Then, heating was carried out at 150 °C for 1 hour to form a reflection layer. A wavelength conversion layer-forming composition was potted into the package in which the reflection layer was formed using a dispenser to form a wavelength conversion layer in the package in the same manner as in Comparative Example 1.

### (6) Evaluation of LED Device

For each of the LED devices produced in Examples 14 to 20, the thickness of the reflection layer, total luminous flux value, total luminous flux value after durability test, deterioration rate, and adhesion were evaluated by the methods similar to those in Example 1. The results are shown in Table 2.

**[Table 2]**

| | Reflection Layer | | | | | Evaluation | | | | |
|---|---|---|---|---|---|---|---|---|---|---|
| | Light Diffusion Particles | Binder | Polysiloxane Bifunctional: Trifunctional (Polymerization Ratio) | Metal Oxide Microparticles | Metal Alkoxide /Metal Chelate | Film Thickness (µm) | Total Luminous Flux Value (Relative Value) | Total Luminous Flux Value After Luminescence Test (Relative Value) | Deterioration Rate (%) | Adhesion |
| Ex.14 | Titanium Oxide | Polysiloxane | 1:9 | - | - | 5 | 105 | 94 | 10 | B |
| Ex.15 | Titanium Oxide | Polysiloxane | 1:9 | - | - | 50 | 150 | 137 | 9 | B |
| Ex.16 | Titanium Oxide | Polysiloxane | 1:9 | - | - | 200 | 153 | 138 | 10 | B |
| Ex.17 | Titanium Oxide | Polysiloxane | 1:9 | - | - | 250 | 153 | 137 | 10 | B |
| Ex.18 | Titanium Oxide | Polysiloxane | 3:7 | - | - | 50 | 147 | 135 | 8 | B |
| Ex.19 | Titanium Oxide | Polysiloxane | 4:6 | - | - | 50 | 145 | 132 | 9 | C |
| Ex.20 | Titanium Oxide | Polysiloxane | Bifunctional: | - | - | 50 | 148 | 133 | 9 | B |
| | | | Trifunctional: | | | | | | | |
| | | | Tetrafunctional 1:7:2 | | | | | | | |
| Ex.21 | Titanium Oxide | Polysiloxane | 1:9 | Zirconium Oxide | - | 50 | 151 | 138 | 9 | B |
| Ex.22 | Titanium Oxide | Polysiloxane | 1:9 | Zirconium Oxide | Zirconium Chelate | 50 | 149 | 137 | 8 | A |
| Ex.23 | Titanium Oxide | Polysiloxane | Bifunctional: | Zirconium Oxide | - | 50 | 147 | 135 | 8 | B |
| | | | Trifunctional: | | | | | | | |
| | | | Tetrafunctional 1:7:2 | | | | | | | |
| Ex.24 | Titanium Oxide | Polysiloxane | Bifunctional: | Zirconium Oxide | Zirconium Chelate | 50 | 150 | 137 | 9 | A |
| | | | Trifunctional: | | | | | | | |
| | | | Tetrafunctional 1:7:2 | | | | | | | |

As shown in Table 2, in the case where polysiloxane is a polymer of a bifunctional silane compound and a trifunctional silane compound (Examples 14 to 19, 21, and 22), as well as in the case where polysiloxane is a polymer of a bifunctional silane compound, a trifunctional silane compound, and a tetrafunctional silane compound (Examples 20, 23, and 24), not only the total luminous flux value immediately after the production of an LED device was higher, but also the total luminous flux value after durability test was higher (deterioration rate was lower).

However, in the case where the ratio of a bifunctional silane compound to a trifunctional silane compound was 4:6, the adhesion was somewhat deteriorated. It is deduced that, since many organic groups derived from a bifunctional silane compound are contained in polysiloxane, peeling-off was likely to occur at the interface between the substrate and the reflection layer, or the interface between the reflection layer and the wavelength conversion layer.

On the other hand, in the case where zirconium oxide microparticles and zirconium chelate were added in the reflection layer (Examples 22 and 24), the adhesion at an interface between the respective layers was particularly better. It is deduced that formation of metalloxane bonding by metals contained in the metal alkoxide or the metal chelate with a hydroxyl group on the surface of a substrate made the adhesion better.

### Industrial Applicability

According to the LED device of the present invention, a reflection layer is not deteriorated over time, and thus the out-coupling efficiency thereof remains good over a long period of time. Therefore, the LED device manufactured according to the present invention is suitable for various lighting apparatuses to be used indoors or outdoors, including an automobile headlight that requires larger amount of light.

### Reference Signs List

- 1: Substrate
- 2: LED element
- 3,3': Metal Part
- 4: Interconnection
- 5: Bump electrode
- 6: Cavity Inner Wall Surface
- 11: Wavelength Conversion Layer
- 21: Reflection Layer
- 100: LED Device

## Claims

1. An LED device comprising: a substrate; and an LED element that is mounted on the substrate and configured to emit light of a specific wavelength, wherein the LED device comprises a reflection layer including light diffusion particles composed of inorganic particles and a ceramic binder on a surface of the substrate outside an LED element-mounting area.

2. The LED device according to claim 1, wherein a thickness of the reflection layer is 5 µm or more and 200 µm or less.

3. The LED device according to claim 1, wherein a thickness of the reflection layer is 5 µm or more and 30 µm or less.

4. The LED device according to any one of claims 1 to 3, wherein the substrate has a cavity, and the LED device comprises the reflection layer on an inner wall surface of the cavity.

5. The LED device according to any one of claims 1 to 4, further comprising a wavelength conversion layer that covers the reflection layer and the LED element, wherein the wavelength conversion layer includes a transparent resin and phosphor particles.

6. The LED device according to any one of claims 1 to 5, wherein the light diffusion particles are composed of at least one type of inorganic particles selected from the group consisting of titanium oxide, barium sulfate, barium titanate, boron nitride, zinc oxide, and aluminum oxide.

7. The LED device according to any one of claims 1 to 6, wherein the ceramic binder is a polymer of a trifunctional silane compound and a tetrafunctional silane compound, and a polymerization ratio of the trifunctional silane compound to the tetrafunctional silane compound is 3:7 to 7:3.

8. The LED device according to any one of claims 1 to 6, wherein the ceramic binder is a polymer of a bifunctional silane compound and a trifunctional silane compound, and a polymerization ratio of the bifunctional silane compound to the trifunctional silane compound is 1:9 to 4:6.

9. The LED device according to any one of claims 1 to 8, wherein the reflection layer further includes metal oxide microparticles having a mean primary particle diameter of 5 to 100 nm.

10. The LED device according to claim 9, wherein the metal oxide microparticles are composed of at least one compound selected from the group consisting of zirconium oxide, titanium oxide, cerium oxide, niobium oxide, and zinc oxide.

11. The LED device according to any one of claims 1 to 10, wherein the reflection layer further includes a cured product of a metal alkoxide or a metal chelate of a divalent or higher polyvalent metal element other than Si element.

12. The LED device according to any one of claims 1 to 11, wherein the substrate has a metal part, and the LED device comprises the reflection layer on the surface of the substrate outside the LED element-mounting area and on the metal part.

13. The LED device according to any one of claims 1 to 11, wherein the substrate has a metal part, and the LED device comprises the reflection layer on the surface of the substrate outside the LED element-mounting area and outside an area of the metal part.

14. A method of manufacturing an LED device that includes a substrate, an LED element that is mounted on the substrate and configured to emit light of a specific wavelength, and a reflection layer that is formed on a surface of the substrate outside the LED element-mounting area, the method comprising:
applying a reflection layer-forming composition including light diffusion particles and an organic silicon compound to the surface of the substrate outside the LED element-mounting area to form the reflection layer.

15. The method according to claim 14, wherein the substrate has a metal part, and the method comprises forming the reflection layer on the surface of the substrate outside the LED element-mounting area and on the metal part, in the step of forming the reflection layer.

16. The method according to claim 14, wherein the substrate has a metal part, and the method comprises forming the reflection layer on the surface of the substrate outside the LED element-mounting area and outside an area of the metal part, in the step of forming the reflection layer.

17. The method according to any one of claims 14 to 16, wherein the substrate has a cavity, and the method comprises spray-applying the reflection layer-forming composition to an inner wall surface of the cavity.
